Europäisches Patentamt

European Patent Office

Office européen des brevets

(19)

(11) Publication number: **0 549 801 A1**

## EUROPEAN PATENT APPLICATION
## published in accordance with Art. 158(3) EPC

(12)

(21) Application number: 92912845.2

(22) Date of filing: 24.06.92

(86) International application number:
PCT/JP92/00804

(87) International publication number:
WO 93/00454 (07.01.93 93/02)

(51) Int. Cl.5: **C23C 16/26**, C23C 16/02, B23P 15/28

(30) Priority: 24.06.91 JP 151548/91
27.06.91 JP 155050/91
06.12.91 JP 323263/91
18.02.92 JP 31055/92
19.02.92 JP 31938/92
27.02.92 JP 41224/92

(43) Date of publication of application:
07.07.93 Bulletin 93/27

(84) Designated Contracting States:
BE CH DE FR GB IT LI NL SE

(71) Applicant: IDEMITSU PETROCHEMICAL CO. LTD.
1-1, Marunouchi 3-chome Chiyoda-ku
Tokyo 100(JP)

(72) Inventor: MASUDA, Atsuhiko Idemitsu
Petrochemical Co., Ltd.

1660, Kamiizumi
Sodegaura-shi, Chiba-ken 299-02(JP)
Inventor: MIZUNO, Hiromi
Idemitsu Petrochemical Co., Ltd., 1660,
Kamiizumi
Sodegaura-shi, Chiba-ken 299-02(JP)
Inventor: SAITO, Yoshiaki
Idemitsu Petrochemical Co., Ltd., 1660,
Kamiizumi
Sodegaura-shi, Chiba-ken 299-02(JP)
Inventor: ISOZAKI, Toshio
Idemitsu Petrochemical Co., Ltd., 1660,
Kamiizumi
Sodegaura-shi, Chiba-ken 299-02(JP)

(74) Representative: Hartmann, Günter, Dr.
Dipl.-Chem.
Pienzenauerstrasse 2
W-8000 München 80 (DE)

(54) DIAMOND-COVERED MEMBER AND PRODUCTION THEREOF.

(57) A diamond-covered member composed of a base material having on its surface a solid solution layer comprising at least one member selected from the group consisting of carbides, nitrides and carbonitrides of two or more metals selected among those of the groups IVA, VA and VIA of the periodic table and a diamond layer formed on the solid solution layer, which is extremely high in the adhesion to the base material and suitably applicable to grinding and abrasive tools. It can be produced by heating a base material comprising a specified hard metal or a base material comprising a general hard metal covered with a specified material in an inert gas atmosphere under a specified pressure at 1,000 to 2,000 °C.

Rank Xerox (UK) Business Services
(3.10/3.6/3.3.1)

TECHNICAL FIELD

The present invention relates to a diamond-coated member and a process for the preparation of a member coated with a diamond and, more particularly, to a member coated with a diamond and a process for the preparation thereof, the member coated with the diamond being superior in adhesion between a supporting member and a film of the diamond to be coated thereon, exhibiting high durability, and having remarkably improved life.

BACKGROUND ART

Heretofore, diamond that is remarkably superior in hardness, wear and abrasion resistance and so on, has been extensively employed, for example, as a tool, such as a cutting tool, a grinding tool, and an abrasive tool, and as an abrasion proof member for a mechanical part, and so on, which require a high degree of surface hardness and resistance to wear and abrasion. As a process for the preparation of a diamond, it is generally known, for example, a method for forming a diamond film by depositing the diamond on the surface of a supporting member for a tool or an abrasion proof member by making use of technology of synthesizing the diamond, such as a vapor phase method, e.g. CVD method, PVD method, or the like. By coating the supporting member with the film of the diamond, the tools and the abrasion proof members can be provided with a high degree of surface hardness and resistance to wear and abrasion.

It is to be noted, however, that adhesion between the surface of the supporting member and the film of the diamond is generally poor. Hence, a variety of proposals have been made so far with the attempt to improve the adhesion there between.

As one of such proposals, an attempt has been made to form an intermediate layer consisting of the component of a supporting member and a carbon component on the surface of the supporting member made of a variety of materials and then to form a diamond film (a thin layer of a diamond) on a surface of the intermediate layer with the aid of the vapor phase synthesis method, thereby improving the adhesion between the supporting member and the film of the diamond through the intermediate layer so formed (as disclosed in official gazettes of Japanese Patent Laid-open Publication (kokai) Nos. 60-208,473, 61-106,478, etc.).

For example, the official gazettes of Japanese Patent Laid-open Publication (kokai) Nos. 60-208,473 and 61-106,478 disclose each the method for forming the intermediate layer between the supporting member and the film of the diamond, an intermediate layer consisting of a carbide of a metal, a nitride thereof, or a boron compound thereof. This method, however, does not yet provide a practically sufficient degree of the adhesion of the intermediate layer to both of the supporting member and the film of the diamond.

Further, the official gazette of Japanese Patent Laid-open Publication. (kokai) No. 61-106,494 proposes the method which employs a mixture of a component of the supporting member and diamond. This method, however, cannot impart a sufficient degree of adhesion of the resulting film of the diamond to the supporting member.

As described hereinabove, the technology of forming the intermediate layer is required to satisfy severe conditions (1) that the intermediate layer should achieve a high degree of the adhesion to both of the supporting member and the film of the diamond and, further, (2) that the intermediate layer itself should have a sufficiently high degree of strength. Hence, it is extremely difficult to single out the optimal material. In fact, various means for selecting the material for the intermediate layer and the method for the formation of the intermediate layer have been devised as the conventional methods as exemplified hereinabove; however, the diamond-coated member with the intermediate layer so produced by each of the aforesaid conventional methods does not yet satisfy the conditions (1) and (2) as described hereinabove to a satisfactory extent and, particularly when it is used as a cutting tool, a sliding member, or the like, under severe conditions, it presents the problems with a lack of a sufficient degree of durability and a sufficiently long period of life.

Further, the official gazette of Japanese Patent Laid-open Publication (kokai) No. 62-47,480 proposes a method in which a component of a metal, such as Co, Ni, or the like, is removed in advance by treating the surface of a supporting member consisting of a cermet with an acid. The official gazette of Japanese Patent Laid-open Publication (kokai) No. 61-106,494 also proposes similar technology in which a component of a metal is removed in advance by treating the surface of a supporting member consisting of a cermet with an acid. These methods, however, present the problem that the film of the diamond is likely to come off from the supporting member at a high temperature because a sufficiently high degree of adhesion of the film of the diamond to the supporting member consisting of the cermet cannot be achieved clue to a difference in thermal stress between tungsten carbide and the film of the diamond or for other reasons.

On the other hand, technology is proposed, which forms a thin layer of a diamond on a supporting member of a ceramics type with controlled coefficient of thermal expansion by placing a focus on the facts that a poor adhesion of the thin layer of the diamond to the supporting member is caused by a difference in coefficient of thermal expansion between the thin layer of the diamond and the supporting member and that the coefficient of thermal expansion of a ceramics such as silicon nitride or the like is likely to vary with its composition, its calcining conditions, and so on (as disclosed in the official gazettes of Japanese Patent Laid-open Publication (kokai)Nos. 61-109,628, 61-291,493, 62-107,067, etc.).

In this case, however, the material and the composition of the supporting member are restricted to an extremely narrow scope because it is required to place an importance upon the control of the coefficient of thermal expansion. Hence, even if the adhesion could be improved, there may still be left unsolved the problem that characteristics of the supporting member itself, such as hardness, fracture toughness, and so on, are not yet satisfied to a sufficient extent. In fact, the member coated with the diamond prepared by this conventional method does not provide its diamond tool and its abrasion proof member with a sufficient degree of durability and a sufficiently long period of life.

In addition, a proposal is made to improve the adhesion between a supporting member and a thin layer of a diamond by thermally treating the supporting member in an oxygen atmosphere and then changing a shape of the surface of the supporting member (as disclosed in the official gazette of Japanese Patent Laid-open Publication (kokai) No. 61-97,194, etc.). The fact, however, is such that this method does not provide a thin layer of a diamond, having such a good degree of adhesion as capable of being applied to a member coated with the diamond, such as a tool or the like. Further, it presents the practical problems that a source of heat and so on, which is superior in resistance to oxidation, are required when the supporting member is thermally treated in an atmosphere of oxygen and that devices to be employed therefor becomes very expensive.

Further, the official gazette of Japanese Patent Laid-open Publication (kokai) No. 1-103,992 proposes that a supporting member consisting of a superhard alloy is thermally treated in advance in a vacuum state and a thin layer of a diamond is formed on the resulting supporting member. The adhesion can be improved by thermally treating the supporting member in vacuo in advance; however, in this case, too, the degree of improved adhesion does not yet achieve the level that can be satisfied to a sufficient extent.

Furthermore, the official gazette of Japanese Patent Laid-open Publication (kokai) No. 2-293,385 discloses technology of improving the adhesion by treating the surface of a calcined body containing tungsten carbide as a major component in a decarburized atmosphere to thereby form fine particles of the tungsten carbide on the surface thereof. This process, however, presents the defects that the composition of the supporting member is restricted to a relatively narrow scope and the supporting member should be prepared only by an expensive procedure, such as a hot press method.

A still further proposal is made in the official gazette of Japanese Patent Laid-open Publication (kokai) No. 1-246,361 to the effect that a calcined alloy consisting of a hard layer and a connecting layer is treated with heat or by abrasion, the hard layer containing at least one member selected from a carbide of a metal belonging to the group 4a, 5a, or 6a of the Periodic Table, a nitride thereof, a carbonated compound thereof, a nitroxidized compound thereof, and a mutual solid solution of these compounds, and the connecting layer containing Co and/or Ni as a major component, and then that a coating film consisting of a diamond-like carbon and/or diamond is formed on the surface of the calcined alloy.

However, in instances where the thermal treatment is effected under reduced pressure in such a manner as disclosed in the example of the laid-open official gazette as stated immediately hereinabove, the connecting layer existing on the surface is caused to disappear to thereby improve the adhesion of the film of the diamond to the calcined alloy; however, the adhesion does not yet achieve a practical level.

In order to solve those problems as described hereinabove, the official gazette of Japanese Patent laid-openPublication (kokai) No. 3-115,571 proposes the procedure in which a concentration of the connecting layer on the surface of the supporting member is reduced by the carburizing treatment. This procedure, however, still leaves the problem that, after all, the film of the diamond is likely to come off because a carbon-rich layer of tungsten carbide formed on the surface of the supporting member is so brittle that the film of the diamond is caused to come off due to aggregation in the layer of the tungsten carbide even if the adhesion of the film of the diamond to the layer of the tungsten carbide would be improved.

The present invention has the object to solve the problems as described hereinabove.

More specifically, the object of the present invention is to provide a member coated with a diamond, which is superior in adhesion between a supporting member and a diamond film to be coated thereon, which exhibits a high degree of durability, and which has a remarkably improved period of life.

Another object of the present invention is to provide a process for the preparation of the member coated with the diamond, which is remarkably superior in practical use, which can sufficiently improve adhesion between the supporting member and the film of the diamond by using the supporting member having various superior characteristics such as a sufficiently high degree of toughness, which can exhibit a sufficient degree of practical performance and durability, and which can prolong the life to a great extent, when it is used as a superhard tool such as a cutting tool, etc., an abrasion proof member, and so on.

DISCLOSURE OF INVENTION

In achieving the aforesaid objects of the present invention, a member coated with a diamond according to the present invention is characterized by a supporting member with a layer of a solid solution formed thereon and by a layer of a diamond formed on the layer of the solid solution, the solid solution comprising at least one member selected from the group consisting of a carbide of metals,a nitride thereof, and a carbonitride thereof, the metals comprising two or more metals belonging to group IVA, VA, or VIA of the periodic table.

As for the above-mentioned invention, a thickness of the layer of the solid solution on the member coated with the diamond is preferable at least 0.1 $\mu$m or more.

As for the above-mentioned invention, the layer of the solid solution on the member coated with the diamond is preferably porous.

As for the above-mentioned invention, the layer of the solid solution on the member coated with the diamond has a porosity in the range of preferably from 5% to 80% when the layer of the solid solution is porous.

As for the above-mentioned invention, the layer of the solid solution on the member coated with the diamond has a BET value in the range of from preferably 30 to 300 cm$^2$/gram when the layer of the solid solution is porous.

A method for the preparation of a member coated with a diamond according to the present invention for achieving the objects as described hereinabove is characterized in that, when a material composed of a superhard alloy of a tungsten carbide type is employed as a supporting member, the supporting member is treated with heat having temperatures ranging from 1,200 ° C to 1,600° C in an atmosphere of an inert gas under pressure ranging from ambient pressure, to 3,000 atmospheric pressure, and a film of a diamond is formed on a surface of the supporting member by vapor phase method.

As for the above-mentioned method for the preparation of a member coated with a diamond, the superhard alloy of the tungsten carbide type comprises preferably from 50% to 95% by weight of tungsten carbide, from 1% to 30% by weight of titanium carbide, and from 2% to 20% by weight of cobalt.

As for the above-mentioned method for the preparation of a member coated with a diamond, the superhard alloy of the tungsten carbide type further comprises preferably from 80% to 93% by weight of tungsten carbide, from 3% to 10% by weight of tantalum carbide, and from 4% to 10% by weight of cobalt.

As for the above-mentioned method for the preparation of a member coated with a diamond, as a pre-processing for forming the film of the diamond on the surface of the supporting member treated thermally, the surface of the supporting member is treated preferably with plasma at 10 to 100 torr and 500° to , 100° C in an atmosphere of mixed gases of carbodioxide and hydrogen gas.

Further, a method for the preparation of a member coated with a diamond according to the present invention for achieving the objects as described hereinabove is characterized in that, when a material composed of a cermet is employed as a supporting member, the supporting member is treated with heat in an atmosphere of an inert gas under pressure ranging from ambient pressure to 3,000 atmospheric pressure or below and a diamond film is formed on a surface of the thermally treated supporting member by vapor phase method.

Furthermore, a method for the preparation of a member coated with a diamond according to the present invention for achieving the objects as described hereinabove is characterized in that, when a member made of a superhard alloy with a thin layer of at least one member selected from the group consisting of a metallic titanium, titanium nitride, titanium carbide and titanium carbonitride, formed on a surface of the superhard alloy member, is employed as a supporting member, the supporting member is treated with heat at temperatures ranging from 1,000 ° C to 1,600° C in an atmosphere of an inert gas and then that a film of a diamond is formed on a surface of the thermally treated supporting member by vapor phase method.

In addition, a method for the preparation of a member coated with a diamond according to the present invention for achieving the objects as described hereinabove is characterized in that a supporting member prepared from a ceramics of a silicon nitride type is treated with heat at temperatures ranging from 1,300 ° C to 2,000° C in an atmosphere of a rare gas under pressure ranging from 5 to 3,000 atmospheric pressure and then that a film of a diamond is formed on a surface of the thermally treated supportingmember by vapor phase method.

As for the above-mentioned method for the preparation of a member coated with a diamond, the ceramics of the silicon nitride preferably contains at least one member selected from the group consisting of silicon nitride, $\alpha$ -sialone, and $\beta$ -sialone as a major component.

As for the above-mentioned method for the preparation of a member coated with a diamond, wherein, when at least one member selected from the group consisting of the silicon nitride, $\alpha$ -sialone, and $\beta$ -sialone is employed, the rate thereof in the supporting member is in the range of preferably from 60% to 99% by volume.

Further, a method for the preparation of a member coated with a diamond according to the present invention for achieving the objects as described hereinabove is characterized in that, when a composition comprising from 30% to 95% by volume of at least one member selected from the group consisting of the silicon nitride, $\alpha$ -sialone, and $\beta$ -sialone and from 70% to 5% by volume of at least one member selected from the group consisting of a carbide of a metal, a nitride thereof, a carbonitride thereof, and a boride thereof is employed as a supporting member, is treated with heat at temperatures ranging from 1,400° C to 1,800 ° C in an atmosphere of a nitrogen gas under pressure ranging from 5 to 3,000 atmospheric pressure and then that a film of a diamond is formed on a surface of the thermally treated supporting member by vapor phase method.

The present invention will be described more in detail.

## (1) Diamond-coated member

The diamond-coated member according to the present invention has the supporting member with a layer of the solid solution formed thereon and a layer of the diamond formed on the layer of the solid solution, the solid solution comprising at least one member selected from the group consisting of the carbide of metals, the nitride thereof, and the carbonitride thereof, the metals comprising two or more metals belonging to group IVA, VA, or VIA of the periodic table.

## (1) Supporting member

As the supporting member, the material is determined on the basis of how to form the layer of the solid solution on the surface of the supporting member.

The layer of the solid solution may be formed by transforming the surface of the supporting member itself by heating the supporting member or by forming a film of at least one member selected from the group consisting of the carbide of two or more kinds of the metals, the nitride thereof, and the carbonitride thereof on the surface of the supporting member and then heating the supporting member, the metals selected from the group consisting of the metals belonging to the groups IVA, VA, and VIA of the periodic table.

### a. Example of formation of solid solution by transformation

As a material for the supporting member in the former case, there may be preferably employed a superhard alloy or a cermet, containing two or more kinds of the metals selected from the metals belonging to the groups IVA, VA, and VIA of the periodic table (IUPAC) because it is required to precipitate the components of the solid solution onto the surface of the supporting member from the inside of the supporting member.

As specific examples of the superhard alloys of the tungsten carbide type, there may be mentioned superhard alloys of a type including a W-C type, such as WC, W-WC, WC-C, W-WC-C, etc; a W-Co type, such as WC-Co, WC-Co-W, WC-Co,WC-Co-W-C, etc; a W-Ta-Co type, such as WC-TaC-Co, WC-TaC-Co-C, etc; a W-Ti-Co type, such as WC-TiC-Co, WC-TiC-Co, WC-TiCN-Co, etc; a W-Ti-Ta-Co-C type, such as WC-TaC-Co, WC-TiC-TaC-Co-C, etc; WC-Nb-Co; and so on. The superhard alloy of the tungsten carbide type may be prepared from the tungsten carbides, tantalum carbides, titanium carbides, and so on, as described hereinabove. As the superhard alloys of the tungsten carbide type to be employed for the present invention, it is preferred to use the one containing a metal such as Ti, Co, Ta, Mo, Cr, Ni, or the like.

It can be noted herein that these superhard alloys may contain carbon that is referred to as "free carbon" or the like.

As the preferred specific examples of the superhard alloys of the tungsten carbide type to be employed as the supporting member in the present invention, there may be mentioned the superhard alloys of WC-TiC-Co, WC-TaC-Co, WC-TiC-TaC-Co, WC-Co, and WC-Nb-Co.

As the superhard alloys having the composition of WC-TiC-Co, there may be mentioned a one containing tungsten carbide at the rate of from 50% to 95% by weight, preferably from 70% to 94% by weight; titanium carbide at the rate of from 1% to 30% by weight, preferably from 2% to 20% by weight; and cobalt at the rate of from 2% to 20% by weight, preferably from 4% to 10% by weight.

As the superhard alloys having the composition of WC-TaC-Co, there may be mentioned a one containing tungsten carbide at the rate of from 80% to 93% by weight, preferably from 85% to 92% by weight; tantalum carbide at the rate of from 1% to 20% by weight, preferably from 2% to 10% by weight; and cobalt at the rate of from 3% to 10% by weight, preferably from 4% to 6% by weight.

As the superhard alloys having the composition of WC-TiC-TaC-Co, there may be mentioned a one containing tungsten carbide at the rate of from 30% to 96% by weight, preferably from 74% to 93% by weight; titanium carbide at the rate of from 1% to 30% by weight, preferably from 2% to 10% by weight; tantalum carbide at the rate of from 1% to 20% by weight, preferably from 2% to 10% by weight; and cobalt at the rate of from 2% to 20% by weight, preferably from 3% to 8% by weight.

As the superhard alloys having the composition of WC-Co, there may be mentioned a one containing tungsten carbide at the rate of from 90% to 98% by weight, preferably from 94% to 97% by weight; and cobalt at the rate of from 2% to 10% by weight, preferably from 3% to 6% by weight.

As the tungsten carbide as described hereinabove, there may be employed those as have heretofore been used for tools and so on and, more specifically, there may be mentioned a stoichiometric compound and a nonstoichiometric compound, as represented by WC or $WC_x$ (where x is a positive actual number other than 1 and x is usually a number larger than 1 or smaller than 1), or ones formed, for example, by joining a different element such as oxygen atom to them, substituting some elements of them therefor or penetrating them thereinto. Among them, particularly WC can usually be employed conveniently.

It can be further noted herein that these compounds may be employed singly, in combination with two or more, in admixture with two or more, in the form of a composition with the solid solution, or the like.

The titanium carbide is not restricted to a particular one and there may be employed, for example, a one that may be employed for the preparation of a usual alloy. More specifically, there may be mentioned a stoichiometric compound and a nonstoichiometric compound, as represented by TiC or $TiC_y$ (where y is a positive actual number other than 1 and y is usually a number larger than 1 or smaller than 1), or ones formed, for example, by joining a different element such as oxygen atom to them, substituting some elements of them therefor or penetrating them thereinto. Among them, particularly TiC can usually be employed conveniently.

The tantalum carbide is not restricted to a particular one and there may be employed, for example, a one that may be employed for the preparation of a usual alloy. More specifically, there may be mentioned a stoichiometric compound and a non stoichiometric compound, as represented by TaC or $TaC_z$ (where z is a positive actual number other than 1 and z is usually a number larger than 1 or smaller than 1), or ones formed, for example, by joining a different element such as oxygen atom to them, substituting some elements of them therefor or penetrating them thereinto. Among them, particularly TaC can usually be employed conveniently.

The cobalt is not restricted to a particular one and the metal of a simple substance may be conveniently employed.

The tungsten carbides, the titanium carbides, the tantalum carbides, and the cobalt are not particularly required to be in a pure form and they may contain impurities if their amounts would not exert any adverse influence in order to achieve the objects of the present invention.

For example, the tungsten carbides may contain a minute yet excessive amount of carbon, an metal, an oxide, or the like.

As the cermet to be employed for the present invention, there may be mentioned, for example, a cermet material in which a carbide or a nitride of Ti, W, Mo, Cr, Ta, Nb, V, Zr, Hf, or the like contains a metal such as Co, Ni, Cr, Mo, Fe, or the like, as a calcination aid, and those as generally known as a cermet material may be used without particular restriction.

As specific examples of those cermet materials, there may be mentioned, for example, ones in which WC, $Mo^2C$, $Cr_3C_2$, TaC, NbC, VC, TiC, ZrC, HfC, TaN, NbN, VN, TiN, ZrN, HfN, Ta(C, O), Ti(C, O), Ti(N, O), (W, Ti)C, (W, Ta, Ti)C, (W, Ta, Nb, Ti)C, Ti(C, N), Ti(C, N, O), (Ti, Zr)C, (Ti, Zr)(C, N), or the like, contains Co and/or Ni, Co and/or Ni, Cr, Mo, Fe, or the like, as a calcination aid.

The cermet materials as described hereinabove may also be represented in such a way as will be described hereinafter. In other words, the cermet to be employed for the present invention may be referred to as a one in which WC, TaC or TiN is added to TiC and Ni, Co, or Mo is added to the resulting TiC as a binding phase. As such cermets, there may be mentioned, for example, TiC-TaC-Ni, TiC-TaC-Mo, TiC-TaC-Ni-Mo, TiC-TiN-Ni, TiC-TiN-Mo, TiC-TiN-Ni-Mo, TiC-TiN-TaC-WC-Ni, TiC-TiN-TaC-WC-Mo, TiC-TiN-TaC-WC-Ni-Mo, TiN-TaN-Ni, TiN-TaN-Mo, TiN-TaN-Ni-Mo, TiC-TaN-Ni, TiC-TaN-Mo, TiC-TaN-Ni-Mo, TiC-Ni, TiC-Mo, TiC-Ni-Mo, TiC-Ni, TiC-Mo, TiC-Ni-Mo, TiC-TaN-Ni, TiC-TaN-Mo, TiC-TaN-Ni-Mo, and so on. Further, these cermets may additionally contain other elements or carbides thereof.

Among those as described hereinabove, the cermets of the titanium carbide type, the tungsten carbide type, and the titanium nitride type may be used appropriately. Particularly preferred ones are those cermet materials in which TiC, TiN, TiCN, or the like, contains Ni, Co, or Mo as a calcination aid.

As the solid solution to be employed for the present invention can be formed by causing the metal for the solid solution as will be described hereinafter to precipitate onto the surface of the supporting member even if any one of the superhard alloys and the cermets as described hereinabove would be employed, it is preferred to use the supporting member containing an ingredient capable of forming the solid solution.

It can be thus to be noted herein that there may be employed commercially available ones as the supporting member. Further, when such commercially available ones are not employed, the supporting member may be prepared by formulating appropriate amounts of the ingredients as described hereinabove and then treating the resulting mixture by calcination or any other appropriate procedures.

It can further be noted that as needed, an auxiliary binder or the like, containing ethylene glycol, ethylene-vinyl acrylate, polybutylene methacrylate, adamantane or the like as a major ingredient, may be formulated with the aforesaid ingredients prior to calcination.

The procedures for the calcination are not restricted to a particular one and the calcination may be carried out in accordance with conventional calcination methods.

In the procedures for the calcination, each of the aforesaid ingredients may be employed in the form of powders, finely divided powders, superfine powders, or whiskers, or in any other shapes. Among those ingredients as described hereinabove, there may appropriately be used fine particles or superfine particles having an average particle size ranging usually from approximately 0.05 $\mu$m to 4 $\mu$m, preferably from approximately 1 $\mu$m to 3 $\mu$m or whiskers having an aspect ratio ranging from approximately 20 to 200.

The temperature for the calcination may appropriately range usually from 1,200° C to 1,600° C, preferably from 1,300° C to 1,600° C or from 1,300° C to 1,550° C or from 1,350° C to 1,550° C.

The time required for the calcination may appropriately be usually longer than half an hour, preferably in the range of from approximately one hour to four hours.

The shape of the supporting member to be employed for the preparation of the members coated with the diamond is not restricted to a particular one.

The supporting member may be prepared, for example, by calcining, for example, after the material for the supporting member has been formed in a desired shape for the calcination in advance or by forming the material in a desired shape as needed after calcination, whereby it can be employed as the supporting member for the member coated with the diamond according to the present invention.

b. Example of formation of solid solution by forming a coating of a particular ingredient on a surface of the supporting member

It can be noted in this case that the supporting member is not required to be formed by the ingredients necessary for the formation of the layer of the solid solution if the coating formed on the surface of the supporting member is constituted by two or more metals, each metal belonging to the group IVA, VA, or VIA of the periodic table, or the carbide thereof, the nitride thereof and/or the carbonitride thereof, and the solid solution so referred to in the present invention can be formed by heating.

On the other hand, if the coating formed on the surface of the supporting member is constituted by one kind of the metal selected from the metals belonging to the groups IVA, VA, and VIA of the periodic table or the carbide thereof, the nitride thereof and/or the carbonitride thereof, the material for the supporting member is selected appropriately so as to allow the ingredients of the supporting member to form the layer of the solid solution defined by the present invention, together with the ingredients of the coating, by heating. In this case, the layer of the solid solution as defined by the present invention can be formed by causing, for example, the WC in the supporting member to disperse and migrate onto the surface of the supporting member by heating.

The material of the supporting member to be employed for the formation of the layer of the solid solution by transforming the supporting member itself by heating may be the same in some cases as the raw material for the supporting member to be employed for the formation of the layer of the solid solution by heating after a coating of a particular ingredient has been formed on the surface of the supporting member. In other words, the heat treatment can provide the layer of the solid solution from the coating and the ingredients of the supporting member by preparing the supporting member from the material for the supporting member to be employed for forming the layer of the solid solutions by transforming the supporting member itself by heating, and forming the particular coating on the surface of the resulting supporting member. Hence, although an illustration of the raw materials of the supporting member to be employed for the formation of the layer of the solid solution by forming the particular coating on the surface of the supporting member may overlap with an illustration of the materials of the supporting member to be employed for the formation of the layer of the solid solution by transforming the supporting member itself; however, the former may be illustrated for ready reference in a way as will be described hereinafter.

In other words, such materials for the supporting member are not restricted to particular ones and a variety of kinds and compositions of the materials as generally known to one of ordinary skill may be used: they may include, for example, superhard alloys consisting of one or more metals, such as W, Mo, Cr, Co, Ni, Fe, Ti, Zr, Hf, Nb, Ta, Al, B, Ga, Si, and so on; and superhard alloy shaving a variety of compositions consisting of one or more metals selected therefrom and oxygen and/or boron, or the like (more specifically, for example, a W-C type, such as WC, W-WC, WC-C, W-WC-C, etc; a Co-C type; a Co-W-C type, such as Co-WC, Co-W-WC, Co-WC-C, Co-W-WC-C, etc; a Ta-C type, such as TaCx, etc; a Ti-C type, such as TiC, etc; a Mo-C type, such as a MoCx type, a Mo-MoCx type, a MoCx-C type, etc; a Si-C type, such as SiC, etc; a Fe-C type, such as Fe-FeCx, etc; an Al-Fe-O type, such as an Al2O3-Fe type, etc; a Ti-Ni-C type, such as a TiC-Ni type, etc; a Ti-Co-C type, such as a TiC-Co type, etc; a BN type; a Fe-B-C type, such as a $B_4$C-Fe type, etc; a Ti-N type, such as a TiN type, etc; an Al-N type, such as an AlNx type, etc; a TaN-N type, such as a TaNx type; a W-Ta-Co-C type, such as a WC-TaC-Co-C type, etc; a W-Ti-Co-C type, such as WC-TiC-Co-C type, etc; a W-Ti-Ta-Co-C type, such as a WC-TiC-TaC-Co-C type, etc; a W-Ti-C-N type; a W-Co-Ti-C-N type; and so on).

As particularly preferred ones among those as described hereinabove, there may be mentioned, for example, the superhard alloys of the tungsten carbide type appropriate for cutting tools (more specifically, for example, the superhard alloys of the W-Co-C type, e.g. the WC-Co type, etc. and the superhard alloys of the W-Ti-Ta-Co-C type, e.g. the WC-TiC-TaC-Co type, etc., such as superhard alloy tips for cutting tools and so on, including P series, e.g. use classification symbols (JIS B-4053) P01, P10, P20, P30, P40, P50, etc; M series, e.g. use classification symbols (JIS B-4053) M10, M20, M30, M40, etc; K series, e.g. use classification symbols (JIS B-4053) K01, K10, K20, K30, K40, etc; and superhard alloy tips for draw dice, centers, and cutting tools, etc., and those in which a portion is replaced with Nb). It can further be noted that those as described hereinabove may additionally contain another element or an additive ingredient. The material and the shape of the superhard alloy may be appropriately chosen in accordance with the purpose of use and so on.

In addition to the superhard alloys as described hereinabove, the aforesaid cermets may be used as the material for the supporting member.

## b-1. Coating formed on the surface of the supporting member

As the coating to be formed on the surface of the supporting member, there may be employed at least one kind of the metal selected from the metals belonging to the group IVA of the periodic table (IUPAC), particularly Ti, Zr, and Hf, the metal belonging to the group VA, particularly V, Nb, and Ta, and the metal belonging to the group IVA, particularly Cr, Mo, and W, or the carbide thereof, the nitride thereof and/or the carbonitride thereof.

As more preferred examples among those as described hereinabove, there may be mentioned a metallic titanium, titanium nitride, titanium carbide, titanium carbonitride, a metallic niobium, niobium nitride, niobium carbide, and niobium carbonitride. These materials may be used singly or in composition containing two or more kinds.

Further, as the titanium nitrides, there may be mentioned those as represented, for example, by TiN, TiNx, TiN-Ti, Ti-N, and so on. As the titanium carbides, there may be mentioned those as represented, for example, by TiC, TiCx, TiC-C, TiC-Ti, TiC-Ti-C, Ti-C, and so on. As the titanium carbonitrides, there may be mentioned those as represented, for example, by TiCN, TiC•TiN, TiCx•TiNx, TiC•TiN-C, TiC•TiN-Ti, TiC•TiN-Ti-C, Ti-N-C, and so on.

In other words, as the titanium coating, usually, those as represented by Ti, TiN, TiC or TiCN are preferred, and they may be used in mixture of two or more. Further, there may be used those containing an excessive amount of the Ti component, C component and/or N component in addition to one or more of those as described hereinabove. Furthermore, the coating containing the titanium may additionally an element or component other than Ti, C, and N within the range that does not adversely affect the objects of the present invention.

As procedures for forming the coating on the surface of the supporting member composed of the superhard alloy as described hereinabove, there may be used those conventionally employed, for example, ion plating method, sputtering method, or the like.

A film thickness of the coating is not restricted to a particular one; however, it may be selected usually from the range usually from 100 Å to 50,000 Å , preferably from 1,000 Å to 20,000 Å so as to provide a desired film thickness of the layer of the solid solution. If the film thickness of the coating would be thinner than 100 Å , on the one hand, the effect of the medium layer cannot be expected. If the film thickness of the coating would be thicker than 50,000Å , on the other hand, inner stress may be caused to occur within the medium layer.

- Layer of the solid solution -

## a. Layer of the solid solution

In either of the example in which the layer of the solid solution is formed by transforming the supporting member itself or the example in which the layer of the solid solution is formed by transforming a coating formed on the surface of the supporting member, the resulting layer of the solid solution is constituted by at least one kind of the carbide of the two or more metals selected from the metals belonging to the group IVA, VA, or VIA of the periodic table (IUPAC), the nitride thereof, and the carbonitride thereof.

It is to be noted herein that the term "solid solution" referred to herein may be represented by the general formula, $M^1_{A1}M^2_{A2}C$, or the general formula, $M^1_{A1}M^2_{A2}N$ or the general formula, $M^1_{A1}M^2_{A2}CN$, for example, when the solid solution is constituted by two kinds of the metals.

It is provided, however, that in the above-mentioned formulas, $M^1$ and $M^2$ are intended to mean the metals, different from each other, each being selected from the group IVA (Ti, Zr, and Hf), the group VA (V, Nb, and Ta), and the group VIA (Cr, Mo, and W) of the periodic table (IUPAC) and that the suffixes $A^1$ and $A^2$ are intended to mean each a positive actual number. It can further be noted that, when the solid solution is constituted by three or more kinds of the metals, it may be likewise represented, for example, by the general formula, $M^1_{A1}M^2_{2A}M^3_{A3}M^4_{A4}...M^n_{An}$.

A qualitative description will be made of the state of, for example, $M^1_{A1}M^2_{A2}C$. This state may be described in such a manner, for instance, that the $M^2$ atoms are allowed to penetrate into the lattice of a definite crystalline structure constituted by the $M^1$ atoms and the C atoms or some of the $M^1$ atoms within the lattice of the definite crystalline structure are replaced with the $M^2$ atoms.

The solid solution may be readily determined by the X-ray diffractometry.

The composition and the state of distribution of the metal atoms existing in the state of the solid solution can be confirmed by analyzing the section of the solid solution by means of the Energy Dispersive Analysis of X-rays (EDAX). The results of the analysis of the solid solution with the EDAX reveal that the concentrations of the metalsin the state of the solid solution varies from the surfaceof the supporting member toward the inside thereof.

The metals to be employed for the formation of the solid solution may specifically include, for example, W, Ti, Ta, Mo, Nb, Cr, V, Zr, and Hf.

The composition of the solid solution is not restricted to a particular one and it can be noted, however, that one metal is preferably contained at the rate of 10% to 90% by atom, preferably from 40% to 80% by atom with respect to the total number of the metals and the other metal accounts for the rest, although the rate may depend upon the number of the metals. If the one metal is smaller than 10% by atom or larger than 90% by atom, the adhesion of the resulting layer of the solid solution to the film of the diamond may not be achieved to a sufficient extent. More specifically, when the supporting member is of the W-Ti-C type, preferably, the W atoms may account for from 10% to 90% by atom, the Ti atoms may account for from 10% to 90% by atom; and when the supporting member is of the W-Ti-Ta-C type, preferably, the W atoms may account for from 10% to 90% by atom, the Ti atoms may account for from 20% to 80% by atom, and the Ta atoms may account for from 10% to 30% by atom.

The layer of the solid solution may preferably be in the form of a porous layer. When the layer of the solid solution is porous, it can contribute to the improvement in the adhesion of the film of the diamond to the supporting member due to its anchoring effect. It is noted herein that the porous layer of the solid solution will be sometimes referred to merely as the porous layer in the description which follows.

When the section of the porous layer of the solid solution is observed with the scanning electron microscope (SEM), it is found that the layer of the solid solution is provided with a great number of fine pores.

The porous layer of the solid solution has a porosity in the range of usually from 5% to 80%, preferably from 10% to 80%, more preferably from 15% to 70%. It can be noted that the layer of the solid solution having the porosity within the aforesaid range makes unlikely to cause the film of the diamond to come off from the supporting member because the distortion to be caused at high temperatures by the difference in coefficient of thermal expansion between the film of the diamond and the supporting member can be absorbed effectively. On the other hand, if the porosity of the layer of the solid solution would be less than the lower value of the aforesaid range, the tendency of the unlikelihood of the film of the diamond to come off from the supporting member cannot be reduced because the lesser porosity makes it difficult to absorb the distortion loaded at high temperatures by the difference in the coefficient of thermal expansion between the film of the diamond and the supporting member to a sufficient extent. If the porosity of the layer of the solid solution would be larger than the upper value of the aforesaid range, the film of the diamond becomes likely to come off from the supporting member because the strength of the porous layer itself becomes so small that the porous layer suffers from the difficulty of effectively exhibiting the functions as the medium layer existing between the film of the diamond and the supporting member.

When the pores of the porous layer are observed with the SEM, it is found that, for instance, some of the pores are formed at the surface of the porous layer yet they do not reach the substantial depth of the supporting member and some of the pores are formed in such a manner as being communicated with the adjacent pores. Further, the observation of the surface of the porous layer with the SEM makes it apparent that the pores exist as if archipelagos.

It can be noted herein that the pores in the porous layer of the solid solution are sustained even after the film of the diamond is formed on the surface of the porous layer. In other words, when the section of the member coated with the diamond formed on the surface of the supporting member with the porous layer formed thereon is observed with the SEM, it is found that the pores still exist in the porous layer. This state may be described in such a way that the openings of the pores at the surface of the porous layer are covered with the film of the diamond. In this state, it is preferred that the porosity of the porous layer after the surface of the porous layer is covered with the film of the diamond is in the range of from 5% to 70%, more particularly from 30% to 60%.

It can further be noted herein that the porosity of the porous layer after the formation of the film of the diamond (this porosity being sometimes referred to as merely "porosity after formation" hereinafter) is seen tending to decrease to a smaller rate than the porosity of the porous layer before the formation of the film of the diamond (this porosity being sometimes referred to as merely "porosity before formation" hereinafter). It may be understood that the decrease in the porosity after formation from the porosity before formation means that the film of the diamond formed on the porous layer are entered into some pores of the porous layer. In this sense, when the porosity after formation exists within the range as described hereinabove, it can be considered that the porous layer contributes to the improvements in the adhesion of the film of the diamond to the supporting member due to the anchoring effect and so on offered by the film of the diamond entering into the pores of the porous layer.

The porosity in the porous layer can be measured and evaluated with a mercury porosimeter.

It is further to be noted that, when the porosity of the porous layer is observed in terms of the specific surface area, the BET value is in the range preferably from 30 $cm^2$ to 300 $cm^2$ per gram, more preferably from 50 $cm^2$ to 250 $cm^2$ per gram. When the BET value of the porous layer exists within the range as described hereinabove, the mechanical strength of the porous layer itself can be maintained and the adhesion of the film of the diamond can be improved by the alleviation of the internal stress and the anchoring effect offered by the film of the diamond.

The degree of roughness, Ra, on the surface of the layer of the solid solution (this surface being also referred to as the surface of the supporting member) may range usually from 0.05 $\mu$m to 2.0 $\mu$m, preferably from 0.1 $\mu$m to 1.0 $\mu$m. If the surface roughness Ra would be larger than the upper value of the range as described hereinabove, theadhesion of the film of the diamond to the layer of the solid solution may be rather decreased. On the other hand, if the surface roughness Ra would be smaller than the lower value of the range, the adhesion of the film of the diamond may also be lowered.

It is preferred that the thickness of the layer of the solid solution formed on the surface of the supporting member should be as uniform and thin as possible. If the layer of the solid solution is too thick, the film of the diamond formed provides the tendency to become brittle. The thickness of the layer of the solid solution may be usually 0.1 $\mu$m or thicker, preferably in the range of from 0.5 $\mu$m to 30 $\mu$m, more preferably in the range of from 1 $\mu$m to 10 $\mu$m. Further, the thickness of the porous layer of the solid solution may range particularly from 0.1 $\mu$m to 40 $\mu$m. The thickness of the layer of the solid solution may be determined by the following procedure. In other words, the thickness of the layer of the solid solution can be determined by cutting the supporting member with the layer of the solid solution with a diamond wheel and observing the cut section with the SEM.

It can further be noted herein it is more preferred to form the layer of the solid solution in such a manner that the composition of the layer of the solid solution varies continuously so as to thereby result in the composition of the supporting member than to form the layer of the solid solution with a definite interface with the composition of the supporting member. Further, it is preferred that the layer of the solid solution covers the substantially entire surface area of the supporting member; however, no big difficulty is caused to occur even if there would be left an area on the surface of the supporting member not coated with the layer of the solid solution over the range that does not impede the objects of the present invention.

b. Formation of the layer of the solid solution

The layer of the solid solution can be formed on the basis of the interaction between the particular coat layer and the supporting member by transforming the surface of the supporting member by treating the supporting member by application of heat thereto or by forming the particular coat layer on the surface of the supporting member and thereafter treating the particular coat layer by application of heat thereto.

The treatment by the application of heat to the supporting member for the transformation of the surface of the supporting member may be carried out by heating the surface of the supporting member in an atmosphere of an inert gas at a constant pressure.

As the inert gases, there may be mentioned nitrogen gas, rare gases such as argon gas, helium gas, neon gas, xenon gas, and so on. Among those inert gases, particularly argon gas can appropriately be employed.

If gases reactive with the supporting member, such as oxygen gas or the like, would be contaminated in the inert gases, they are caused to react with the supporting member. It is thus desired that such reactive gases be removed as much as possible from the inert gases.

Although the pressure may vary to a minute extent with the kind of the supporting members, the pressure may generally be usually ambient atmosphere or lower than 3,000 atm, preferably in the range of from 5 to 3,000 atm, more preferably from 1,000 to 3,000 atm. If the pressure would be lower than ambient pressure, on the one hand, the surface of the supporting member may not be improved to a desired state. If the pressure would exceed 3,000 atm, on the other hand, the effect cannot be expected to be achieved to an extent higher than the effect gained upon application of 3,000 atm.

When the supporting member is made of from 50% to 95% by weight of tungsten carbide, from 1% to 30% by weight of titanium carbide, and from 2% to 20% by weight of cobalt, the pressure to be applied during the thermal treatment may be in the range of preferably from 5 to 3,000 atm, more preferably from 1,000 to 3,000 atm. If the pressure would be lower than 5 atm, the surface of the supporting member may not be transformed to a sufficiently improved extent.

Although the temperature to be applied during the treatment by heating may vary to a minute extent with the kind of the supporting members, the temperature may be in the range of usually from 1,000 ° C to 1,600 ° C, preferably from 1,200 ° C to 1,600 ° C, more preferably from 1,300 ° C to 1,450 ° C. If the temperature would exist outside the aforesaid range, the surface of the supporting member may not be improved to a desired shape.

When the supporting member is made of from 50% to 95% by weight of tungsten carbide, from 1% to 30% by weight of titanium carbide, and from 2% to 20% by weight of cobalt, the temperature to be applied during the thermal treatment may be in the range of preferably from 1,200 ° C to 1,600 ° C, more preferably from 1,300 ° C to 1,450 ° C. If the temperature would exist outside the aforesaid range, the surface of the supporting member may not be improved to a desired shape.

The period of time required for the thermal treatment cannot be determined in a uniform manner because it is determined on the basis of the condition of the temperature; however, it may be set in the range of usually from 1 minute to 500 minutes, preferably from 15 minutes to 300 minutes. If the period of time for the thermal treatment would be shorter than 1 minute, on the one hand,the surface of the supporting member may not be transformed to a sufficient extent. If the thermal treatment would be carried out for longer than 500 minutes, on the other hand, the transformation of the surface of the supporting member proceeds too much, thereby causing an increase in roughness on the surface of the supporting member and producing the risk to cause the supporting member to be deformed. Thus, such a long period of time for the thermal treatment is not preferred.

The thermal treatment may be carried out by appropriate processes including plasma heating, irradiation of light or the like, application of electricity, laser heating, electrolysis, or the like.

When the particular coat layer is formed on the surface of the supporting member and it is then treated by heating, the temperature to be applied for heating the particular coat layer may be in the range of usually from 1,200 ° C to 1,600 ° C, preferably from 1,300 ° C to 1,550 ° C. The atmosphere where to carry out the thermal treatment may contain inert gases, such as argon gas, helium gas, nitrogen gas, or the like. The pressure to be applied during the thermal treatment may be ambient pressure or the pressure elevated at 3,000 atm or lower, preferably in the range of from 5 to 3,000 atm. The ambient gases and the pressure may appropriately be determined on the basis of the kind of the metal to be contained in the coating.

Although the period of time required for the thermal treatment may not be determined in a uniform manner because it is determined on the basis of the condition of the temperature, it may be in the range of usually from 1 minute to 500 minutes, preferably from 15 minutes to 300 minutes. If the period of time required for the treatment by heating would be less than 1 minute, the transformation of the coating may not proceed to a sufficient extent. On the other hand, if the period of time exceeds 500 minutes, the same disadvantages as described hereinabove may occur so that such a long period of time for the thermal treatment is not preferred.

In any case, the thermal treatment may be carried out by conventional procedures including, for example, plasma heating, irradiation of light or the like, application of electricity, laser heating electrolysis, or the like.

The treatment by heating can form the layer of the solid solution on the surface of the supporting member, the layer of the solid solution consisting of at least one member selected from the metals belonging to the groups IVA, VA, and VIA of the periodic table (IUPAC), the carbides thereof, the nitrides thereof, and the carbonitride thereof.

The thermal treatment may cause irregularity to occur on the surface of the layer of the solid solution so formed in the manner as described hereinabove under some conditions of the thermal treatment. In such cases, it is preferred that the surface of the layer of the solid solution be subjected to smooth processing, including rubbing, rapping, polishing, etching, or the like. The smooth processing can improve accuracy in processing on the finish face of a processing material in using a cutting tool, or the like, on the surface of which the thin layer of the diamond is coated.

Further, when the layer of the solid solution formed on the surface of the supporting member is treated with an acid or subjected to plasma treatment, the metallic component for forming the connecting layer, such as Ni, Co, or the like, existing on the surface layer portion, may be removed to a sufficient extent. This treatment provides the member coated with the diamond, in which the thin layer of the diamond of a high purity is coated with high adhesion, during the period of time when the thin layer of the diamond is formed by the vapor phase method.

(2) Diamond-coated member

a. Member coated with the diamond

The diamond formed on the surface of the solid solution existing on the surface of the supporting member is a polycrystalline diamond formed in the form of a film. In accordance with the present invention, the film may further contain a diamond partially containing a diamond-like carbon, or a diamond-like carbon, to be allowed to be contained within the range that does not impair the object of the present invention.

The presence of the diamond and the diamond-like substance can readily be determined by Raman spectroscopy, and the state in which the diamond deposits can be confirmed by the SEM (scanning electron microscope).

The thickness of the thin layer of the diamond to be formed on the surface of the solid solution of the supporting member cannot be determined in a uniform manner because it varies with the purposes of use of the member coated with the diamond. For tools, the thickness of the thin layer of the diamond may appropriately be usually 1 $\mu$m or thicker, preferably in the range of from 3 $\mu$m to 50 $\mu$m or thicker. If the thin layer of the diamond is too thin, the surface of the supporting member cannot be coated to a sufficient extent.

b. Process for forming a coating of the diamond

In accordance with the present invention, the thin layer of the diamond can be coated on the surface of the layer of the solid solution by thermally treating the supporting member in the manner as described hereinabove. Further, it is preferred that, when the amount of titanium, tantalum, or the like, is contained in the layer of the solid solution at the lesser rate, the supporting member is subjected to plasma processing at particular conditions as pre-processing and the thin layer of the diamond is then coated on the surface of the supporting member.

The plasma processing may be carried out in atmosphere of mixed gases consisting of carbon dioxide gas and hydrogen gas at a pressure range of from 10 Torr to 100 Torr and at a temperature range of from 500 ° C to 1,100 ° C.

The mixed gases may usually consist of from 60% to 90% of carbon dioxide gas and from 40% to 10% of hydrogen gas. The pressure at the time of the plasma processing may preferably be in the range of from 10 torr to 100 torr. If the pressure is higher than the upper limit of the aforesaid range, on the one hand, the processing may be controlled in a poor manner. If the pressure is lower than the lower limit thereof, on the other hand, it may take a longer time for the processing. Further, the temperature on the surface of the supporting member may be in the range of from 500° C to 1,100° C, preferably from 700° C to 900° C. If the temperature would be higher than the upper limit of the aforesaid range, the processing maybe controlled in a poor manner and the reproductivity becomes poor. On the other hand, if the temperature is lower than the lower limit of the aforesaid range, it may take a longer time for the processing. The period of time required for the processing may be in the range of from 1 minute to 200 minutes, preferably 60 minutes.

The plasma can be generated from the mixed gases consisting of carbon dioxide gas and hydrogen gas preferably by the CVD methods. As the CVD methods for the plasma processing, there are known various methods including, for example, microwave plasma CVD, high-frequency plasma CVD, heat filament CVD, and DC arc CVD. Although any of those CVD methods may be employed in the pre-processing, the microwave plasma CVD method and the high-frequency plasma CVD method can preferably be employed as a pre-processing step. It can further be noted that the use of CVD methods is advantageous in terms of structures of devices, which may be adopted for the synthesis of a diamond in a vapor phase and which may be carried out in such a manner as will be described hereinafter.

The plasma processing carried out in the manner as described hereinabove can serve as activating the surface of the supporting member and increasing the binding force between the supporting member and the diamond in preparing the member coated with the diamond according to the present invention.

It can be noted, however, that the process to be employed for the present invention can provide the thin layer of the diamond on the surface of the layer of the solid solution formed in the manner as described hereinabove, regardless of whether or not the pre-processing step is carried out.

It should be noted herein that the term "a diamond" and related terms referred to herein are intended to contain diamond, a diamond partially containing a diamond-like carbon, and a diamond-like carbon.

A variety of the procedures for the formation of the thin layer of the diamond is known and it is not restricted to a particular one for the present invention, although the present invention can appropriately employ the procedure for the synthesis of the diamond in the vapor phase using gases originating from a carbon source, which may be carried out in such a manner as will be described hereinafter.

As the carbon sources to be employed for generating gases to be employed for the formation of the diamond, there may be mentioned, for example, a paraffinic hydrocarbon, such as methane, ethane, propane, butane, etc.; an olefinic hydrocarbon, such as ethylene, propylene, butylene, etc.; an acetylenic hydrocarbon, such as acetylene, allylene, etc.; a diolefinic hydrocarbon, such as butadiene, allene, etc.; an alicyclic hydrocarbon, such as cyclopropane, cyclobutane, cyclopentane, cyclohexane, etc.; an aromatic hydrocarbon, such as cyclobutadiene, benzene, toluene, xylene, naphthalene, etc.; a ketone, such as acetone, diethyl ketone, benzophenone, etc.; an alcohol, such as methanol, ethanol, etc.; other oxygen-containing hydrocarbons; an amine, such as trimethyl amine, triethyl amine, etc.; other nitrogen-containing hydrocarbons; carbon dioxide, carbon monoxide, carbon peroxide, etc.; and so on.

Among those carbon sources, preferred are the paraffinic hydrocarbons such as methane, ethane, propane, etc., the alcohols such as ethanol, methanol, etc., the ketones such as acetone, benzophenone, etc., the amines such as trimethyl amine, triethyl amine, etc., carbon dioxide gas, and carbon monoxide. Further, carbon monoxide is particularly preferred.

It can be also noted that the carbon sources as described hereinabove may be used singly or in admixture of two compounds or more.

In usual cases, the gases originated from the carbon sources can be employed in admixture with active gases such as hydrogen gas or inert gases such as helium, argon, neon, xenon, or nitrogen. The concentration of the gases originated from the carbon sources cannot be determined in a uniform manner because it varies with the kind of the gases to be employed; however, it may be in the range of usually from 0.5% to 50% by volume, preferably from 1% to 20% by volume. If the concentration of the gases originated from the carbon sources is too high, there can be seen the tendency that the amount of the carbon-like diamond in the coating of the diamond increases.

The thin layer of the diamond may be formed by conventional methods including, for example, various vapor phase methods for the synthesis of the diamond, such as CVD methods, PVD methods, or a combination of those methods. Among those methods, in usual cases, there may appropriately be used various heat filament methods including EACVD method, various DC plasma CVD methods including heat plasma method, and microwave plasma CVD methods including heat plasma method.

The conditions for the formation of the thin layer of the diamond are not restricted to particular ones and the reaction conditions which can usually be applied to the aforesaid vapor phase synthesis can also be employed.

For example, the reaction pressure may be in the range of usually from $10^{-6}$ to $10^3$ Torr, preferably from 1 Torr to 800 Torr.

If the pressure would be lower than $10^{-6}$ Torr, the velocity of the formation of the thin layer of the diamond may become too slow. On the other hand, if the pressure would be higher than $10^3$ Torr, any effect cannot be expected to be attained to an extent higher than the effect to be achieved by the application of $10^3$ Torr.

The temperature on the surface of the supporting member cannot be determined in a uniform manner because it varies with the procedures for activating the gases as raw material, or the like; however, in usual cases, it may range from 300° C to 1,200° C, preferably from 450° C to 1,000° C.

If the temperature on the surface of the supporting member would be lower than 300 ° C, on the one hand, the formation of the thin layer of a crystalline diamond may proceed only to an insufficient level. If the temperature would exceed 1,200° C, on the other hand, the thin layer of the formed diamond may become likely to be etched.

The reaction time is not restricted to a particular one, and it may optionally be set in accordance with the velocity of the formation of the thin layer of the diamond, so as to produce the thin layer of the diamond in a desired thickness.

As has been described hereinabove, the process according to the present invention can produce the diamond by reacting the gases originated from the carbon sources with the metal contained in the layer of the solid solution and carbonating the metal of the solid solution, in forming the thin layer of the diamond on the surface of the layer of the solid solution, thereby capable of improving the adhesion between the layer of the solid solution and the thin layer of the diamond.

The members coated with the diamond according to the present invention can be prepared by the process according to the present invention as described hereinabove.

(2) Processes for the preparation of the members coated with the diamond

The modes of the processes according to the present invention as described hereinabove can provide the diamond-coated members with a high degree of adhesion of the thin layer of the diamond to the supporting member by forming the thin layer of the diamond on the surface of the layer of the solid solution existing on the surface of the supporting member; however, it can be noted herein that the diamond-coated members having a high degree of adhesion between the thin layer of the diamond and the supporting member can be prepared by other modes of the processes according to the present invention, in addition to the modes of the processes as described hereinabove.

The other modes of the processes according to the present invention for the preparation of the members coated with the diamond may involve mainly subjecting a supporting member prepared from ceramics of a silicon nitride type to the thermal processing in an atmosphere of rare gases at temperature ranging from 1,300° C to 2,000° C at pressure ranging from 5 to 3,000 atm and forming a film of the diamond on the surface of the resulting supporting member by the vapor phase method; or subjecting the supporting member consisting of 30% to 95% by volume of at least one member selected from the group consisting of the silicon nitride, $\alpha$-sialone, and $\beta$-sialone and from 70% to 5% by volume of at least one member, as a remaining ingredient, selected from the group consisting of the carbide of the metal, the nitride thereof, and a boride of the metal, to the thermal treatment in an atmosphere of nitrogen gas at temperature ranging from 1,300° C to 2,000° C and at pressure ranging from 5 to 3,000 atm and then forming the film of the diamond on the surface of the supporting member by the vapor phase method.

The modes of the processes according to the present invention can improve the adhesion of the thin layer of the diamond to the supporting member to are remarkably high extent by changing the properties of the surface of the supporting member by subjecting the ceramics of the silicon nitride type to heating processing at the particular temperature and at the pressure in the presence of the rare gases or nitrogen gases. Although the reasons why the processes according to the present invention can improve the adhesion of the thin layer of the diamond to a great extent by subjecting the supporting member to the heating processing in the pressurized atmosphere of the rare gases or the nitrogen gas are not clarified yet, the present inventors consider them in a manner as will be described hereinafter.

In other words, when the supporting member consisting of the ceramics of the silicon nitride type containing silicon nitride is subjected to the heating processing in the particular pressurized atmosphere of the rare gases or the nitrogen gas, it can be observed that fine crystalline particles of the silicon nitride on

14

the surface of the supporting member, which are supposed to be composed of $Si_3N_4$, are transformed to a bulky state. When the supporting member consisting of the ceramics of the silicon nitride type containing the sialone is subjected to the heating processing in the pressurized atmosphere of the rare gases, it can be observed that fine crystalline particles of the silicon nitride on the surface of the supporting member, which are supposed to be composed of the sialone, are transformed to a bulky state. It can be noted that the fine crystalline particles of the silicon nitride or the sialone, which are transformed from the ingredient of the supporting member by the heating processing, can be provided with a sufficient degree of roughness in a microscopic level on the plane of the supporting member. It can further be noted that a high degree of the adhesion between the supporting member and the thin layer of the diamond can be attained by a certain kind of a carbide which is formed as a result of reaction with the diamond and which offers the high anchoring action to the thin layer of the diamond and the chemical bonding between the thin layer of the diamond and the supporting member.

On the other hand, in the conventional steps of the preparation of the diamond-coated members of this kind, even if the supporting member consisting of the ceramics of the silicon nitride type is employed, for instance, the supporting member is subjected to grinding processing (processing for scratching the surface of the supporting member) with diamond granules or the like, without Subjecting the supporting member to the heating processing under the particular conditions as described hereinabove, and the thin layer of the diamond is formed on the plane of the supporting member having scratches. Hence, the conventional processes cannot provide a sufficient degree of adhesion between the supporting member and the thin layer of the diamond. The reasons are considered to be based on the small anchoring action of the film of the diamond against the supporting member because the characteristics of the plane of the supporting member, particularly roughness and a chemical affinity of the surface of the supporting member, may not be controlled in a sufficient manner.

The present invention will be described in detail in a manner as will be described hereinafter.

(1) Supporting member

As the ceramics of the silicon nitride type to be employed as the material constituting the supporting member for the present invention, there may be employed ceramics containing at least one member selected from the group consisting of the silicon nitride, $\alpha$-sialone, and $\beta$-sialone.

In this case, the preferred amount of the silicon nitride, $\alpha$-sialone, or $\beta$-sialone (these compounds being sometimes referred to hereinafter as a silicon nitride ingredient) may be in the range of usually from 60% to 99% by volume, particularly from 80% to 95% by volume. If the remaining ingredient of the ceramics, except for at least one member selected from the group consisting of the silicon nitride, $\alpha$-sialone, and $\beta$-sialone, would comprise at least one member selected from the group consisting of the carbide of the metal, the nitride thereof, and the boride thereof, the preferred amount of the silicon nitride, $\alpha$-sialone, and $\beta$-sialone may be in the range of usually from 30% to 95% by volume, preferably from 40% to 70% by volume. It can be noted herein that the percentage by volume may be defined by the charging composition on the basis of the amount of the charged raw material.

If the rate of the silicon nitride ingredient would be less than 60% by volume, toughness of the supporting member itself may become insufficient, although the objects of the present invention could be achieved. Further, the desired effect for improving the adhesion between the thin layer of the diamond and the supporting member cannot be attained to a sufficient extent even if the heating processing would be carried out at the particular conditions, so that the objects of the present invention may not be achieved to a sufficient extent. If the rate of the silicon nitride ingredient in the supporting member would be less than 60% by volume, the concentration of the silicon nitride ingredient becomes too small so that it can be understood that the fine crystalline particles of $Si_3N_4$ or sialone may not be transformed to a sufficient extent and, as a result, that the trans-formation of the surface of the supporting member for facilitating the adhesion of the thin layer of the diamond cannot be achieved to a sufficient extent.

It can be noted, however, that in instances where the supporting member is formed from the ceramic consisting of at least one member selected from the group consisting of the silicon nitride, $\alpha$-sialone, and $\beta$-sialone and at least one member selected from the group consisting of the carbide of the metal, nitride thereof, and boride thereof, the objects of the present invention can be achieved when the rate of the silicon nitride would be up to 30% by volume, even if the rate of the silicon nitride would be less than 60% by volume.

On the other hand, if there would be employed the supporting member containing the silicon nitride ingredient at the rate exceeding 99% by volume, there may be the occasions where it may become difficult to Sufficiently demonstrate a variety of preferred effects to be attained by the addition of other appropriate ingredients (such as the effects for improving the hardness and for controlling the coefficient of thermal expansion, and the likelihood to sinter the ceramics as the supporting member) because the characteristics of the silicon nitride ingredient itself are caused to increase too much, although the objects of the present invention could be achieved.

In addition, when the supporting member is prepared from the ceramics made of at least one member selected from the group consisting of the silicon nitride, $\alpha$-sialone, and $\beta$-sialone and at least one member selected from the group consisting of the carbide of the metal, nitride thereof, and boride thereof, the objects of the present invention can be achieved to a good extent if the silicon nitride ingredient would be contained at the rate of up to 95% by volume; however, if the rate of the silicon nitride ingredient would exceed 95% by volume, to the contrary, the characteristics of the silicon nitride ingredient may become so high that it may become difficult to offer a variety of preferred effects (such as the effects for improving the hardness and for controlling the coefficient of thermal expansion) to be expected to be achieved by the addition of the other appropriate ingredients.

It can be noted herein that the preferred range of the rates of the silicon nitride ingredient in the supporting member may appropriately be determined by experiments because it generally varies in accordance with the kind of the other ingredients to be employed with the silicon nitride ingredient, a combination of the other ingredients, the conditions for subjecting the supporting member to the heating processing, or the like.

As has been described hereinabove, the ceramics of the silicon nitride type constituting the supporting member to be employed for the process according to the present invention contains the silicon nitride ingredient as a major ingredient. Further, as the remaining ingredients in the ceramics of the silicon nitride type, there may be mentioned a carbide of a metal, a nitride thereof, a boride thereof, alumina, silicon carbide, cubicboron nitride, diamond, and so on.

The remaining ingredients such as the nitrides of the metal and so on can provide the supporting member with the action for sustaining a sufficient degree of hardness, heat resistance, and resistance to oxidation.

As the carbides of the metal, there may be mentioned, for example, tungsten carbide, titanium carbide, tantalum carbide, hafnium carbide, and so on.

The nitrides of the metal may include, for example, titanium nitride, tantalum nitride, hafnium nitride, and so on.

As the borides of the metal, there may be mentioned, for example, boron carbide, titanium boride, and so on.

Further, it can be noted herein that, among the carbides of the metal, in particular, the tungsten carbide, as represented generally by WC, can preferably be employed. In other words, in accordance with the present invention, the ceramics of the silicon nitride type insisting of the silicon nitride and the tungsten carbide may preferably be employed as the supporting member. Among the ceramics of the silicon nitride types, a sintered body consisting of silicon nitride ($Si_3N_4$) and tungsten carbide (WC) or containing them as major ingredients may particularly be employed in an appropriate manner.

In addition, when the supporting member is of a silicon nitride-tungsten carbide (WC) type it can be noted herein that it is of significance to set the rate of the silicon nitride within the particular range as described hereinabove. In this case, if the rate of the tungsten carbide would exceed 70% by volume, toughness of the supporting member itself becomes too low (for example, $K_{1c}$, indicative of toughness, of lower than 5.5 MPacm$^{1/2}$), while, to the contrary, the rate of the silicon nitride becomes less than 30% by volume, in this case, so that the effect of the improvements in the adhesion of the thin layer of the diamond may become insufficient as described hereinabove. On the other hand, if the rate of the WC would be less than 5% by volume, the hardness of the supporting member may becomes insufficient (for example, to Hv, indicative of the hardness, of less than 1,600 Kgm$^{-2}$).

The supporting members may be chosen from commercially available ones or prepared as they are employed. Further, the supporting members may be prepared on the basis of various processes including known processes. For example, in usual cases, the supporting members may conveniently be prepared, for example, by mixing the silicon nitride ingredient, such as $Si_3N_4$, in the form of fine particles, the ingredient of the carbide of the metal, such as WC, in the form of fine particles, and an appropriate kind of a sintering aid to a satisfactory level and sintering the resulting mixture with a hot press at temperature ranging from 1,600° C to 1,700° C in an atmosphere of nitrogen gas, thereby producing a ceramics of the silicon nitride type having a predetermined composition.

Further, it can be noted herein that, among the nitrides of the metals, in particular, the titanium nitrides, as represented generally by TiN, can preferably be employed. In other words, the ceramics of the silicon nitride type consisting of the silicon nitride ingredient and titanium nitride can preferably be employed as the supporting members. In particular, as the supporting members, there can conveniently be employed a sintered body consisting of silicon nitride ($Si_3N_4$) and titanium nitride (TiN) or containing them as major ingredients.

When the supporting member is of the silicon nitride ingredient-titanium nitride (TiN) type, it can be noted herein that it is desired that the rate of the silicon nitride ingredient should be set within the particular range as described hereinabove. In this case, if the rate of the titanium nitride would exceed 40% by volume,toughness of the supporting member itself becomes too low(for example, to $K_{1c}$, indicative of toughness, of lower than 5.5 MPacm$^{1/2}$), while, to the contrary, the rate of the silicon nitride ingredient in this case becomes less than 60% by volume so that the effect of the improvements in the adhesion of the thin layer of the diamond may become insufficient as described hereinabove. On the other hand, if the rate of the TiN would be less than 3% by volume, the toughness of the supporting member itself may become insufficient (for example, to $K_{1c}$, indicative of toughness, of lower than 6.0 MPacm$^{1/2}$). Further, in this case, the supporting members may be chosen from commercially available ones or prepared as they are employed. Further, the supporting members may be prepared on the basis of various processes including known processes. For example, in usual cases, the supporting members may conveniently be prepared, for example, by mixing the silicon nitride ingredient, in the form of fine particles, the ingredient of the nitrides of the metal such as TiN, in the form of fine particles, and an appropriate kind of a sintering aid to a satisfactory level and sintering the resulting mixture by gas pressure sintering method at temperature ranging from 1,700°C to 1,900°C in an atmosphere of nitrogen gas, thereby producing a ceramics of the silicon nitride type having a predetermined composition.

It can be noted herein that no sintering aid may be required when the supporting members are prepared from the ceramics composed of at least one member selected from the group consisting of the silicon nitride, $\alpha$-sialone, and $\beta$-sialone and at least one member selected from the group consisting of the carbide of the metal, nitride thereof, and boride thereof.

(2) Processing by heating

a. First mode of heating processing procedures

In the process according to the present invention, the supporting member is processed, prior to the formation of the thin layer of the diamond on the surface of the supporting member, by subjecting the supporting member prepared from the ceramics of the silicon nitride type containing the sintering aid to the heating processing under particular conditions, that is, at temperature ranging from 1,300°C to 2,000°C, preferably from 1,350°C to 1,750°C, in an atmosphere of rare gases pressurized at pressure ranging from 5 to 3,000 atm.

In this case, the supporting members to be processed by heating may have a variety of shapes and sizes, and they may conveniently be subjected to surface treatment on their entire surface area or on their predetermined partial surface areas in advance by physical or chemical means in conventional manner. Further, the supporting members may conveniently be provided with an appropriate degree of roughness on their planes in advance by conventional grinding processing or any other conventional procedures.

It can be noted herein that the rare gases to be employed in the modes of the above processes may include helium, neon, argon, krypton, and so on.

When the processing by heating hereinabove the supporting members at high temperature in the range as described hereinabove is carried out at low pressure, not in the predetermined pressurized atmosphere of the rare gases, the silicon nitride ingredient in the supporting member may be caused to decompose and an undesirable reaction may be caused to occur. Further, in instances where the processing by heating the supporting member may be carried out only at such a condition as in an atmosphere other than the rare gases or as at pressure of rare gases of less than 5 atm, the improvements in the adhesion between the supporting member and the thin layer of the diamond may become insufficient because the pressure of the rare gases are too low even if the temperature would exist in the range as described hereinabove. In addition, in some cases, the supporting members may be caused to be curved as a result of the reaction of the silicon nitride ingredient with the other additive ingredients. It is preferred that the pressure of the rare gases should generally be higher; however, even if the pressure would exceed 3,000 atm and then the pressure of rare gases would increase, the effect for further improving the adhesion of the thin layer of the diamond to the supporting member can be little recognized and rather it suffers from the disadvantage that costs of production may be caused to increase due to an increase in surpluses of pressure. It can be noted herein that the preferred range of the pressure of the rare gases may be in the range of usually from 9.5 to 2,000 atm.

In instances where the supporting members are heated only in the temperature range as low as lower than 1,300 ° C, on the one hand, no improvements can be achieved in the characteristics of the supporting members to a sufficient extent due to the transformation of the fine particle particles of the silicon nitride ingredient, even if the pressure of the rare gases would exist in the range as described hereinabove. On the other hand, in instances where the heating processing would be carried out at temperature higher than 2,000 ° C, particles of silicon nitride may grow to an abnormal extent, thereby impairing desirable characteristics as the supporting members made of the ceramics of the silicon nitride type, causing obstacles such as distortion of the supporting members, and increasing costs of energy.

Although the heating processing does not require any retention time in usual instances, the retention time may be set to as long as shorter than 4 hours. If the retention time should be ensured, it is preferred that the retention time may be set to as long as from 1 hour to 2 hours.

By subjecting the supporting member to the above-mentioned heating processing at the particular conditions as described hereinabove, the fine crystalline particles of the silicon nitride ingredient on the surface of the supporting member can be transformed in the manner as described hereinabove. In this case, the fine crystalline particles of the transformed silicon nitride ingredient may be usually in the form of bulky crystal and they may have mean effective diameters ranging usually from 0.5 $\mu$m to 5 $\mu$m and mean lengths ranging usually from 1 $\mu$m to 10 $\mu$m. By growing the silicon nitride ingredient to the bulky particles in the manner as described hereinabove, the roughness on the surface of the supporting member can be increased in a uniform manner at microscopic level. As an example, Rmax of the supporting member, indicative of roughness on the surface of the supporting member, can be increased, for example, from 0.8 $\mu$m to as long as 2.0 $\mu$m, by the heating processing. Further, although other desired effects can be expected to be attained as the effect for transforming the supporting members by the heating processing, the supporting members processed by the heating processing can be provided with superior characteristics capable of improving the adhesion of the thin layer of the diamond to a remarkable extent, as compared with the conventional supporting members which are not subjected to the processing by heating.

b. Second mode of heating processing procedures

On the other hand, the second mode of the heating processing procedure uses the supporting members made of from 30% to 95% by volume of at least one member selected from the group consisting of the silicon nitride, $\alpha$ -sialone, and $\beta$ -sialone and from 70% to 5% by volume of the remaining ingredient comprising at least one member selected from the group consisting of the carbide of the metal, nitride thereof, and boride thereof. In this case, if no sintering aid is contained in the supporting members, the supporting members can be processed by heating at the particular conditions, that is, at temperature ranging usually from 1,400° C to 1,800° C, preferably from 1,500° C to 1,780° C, in the pressurized atmosphere of nitrogen gas at pressure ranging from 5 to 3,000 atm, prior to the step of forming a coating of the thin layer of the diamond on the surface of the supporting member.

In instances where the supporting members are subjected to the heating processing, it is preferred that the supporting members to be processed by heating should appropriately be subjected to surface processing in advance by physical or chemical means in accordance with conventional procedures. In this case, for instance, there may appropriately be used the procedure for providing the surface of the supporting member with an appropriate degree of roughness by such grinding processing as being carried out in conventional manner.

In this instance, the pressure to be applied to the heating processing may be in the range of from 5 to 3,000 atm (absolute pressure) as nitrogen ($N_2$) pressure. Hence, when mixed gases consisting of nitrogen gas and other gases are employed as gases for choosing the atmosphere, the total pressure can be chosen from the pressure range of from (5 + P)atm to (3,000 + P)atm, when the sum of the partial pressure of the other gases is represented as P. Further, in usual cases, the processing by heating may conveniently be carried out in an atmosphere of pure nitrogen gas.

If the processing by heating the supporting members at high temperature within the temperature range as described hereinabove can be carried out at low pressure, not in the predetermined pressurized atmosphere, the silicon nitride in the supporting member may be caused to decompose and an undesirable reaction may be caused to occur. Further, in instances where the processing by heating the supporting members is carried out only at the condition at which it is carried out in an atmosphere other than nitrogen gas or at which the pressure of nitrogen gas is less than 5 atm, the pressure of nitrogen gas is too low so that the adhesion between the supporting member and the thin layer of the diamond cannot be improved to a sufficient extent and, in some cases, there may be the occasions that the supporting member may be caused to be curved due to reaction of the silicon nitride with WC or the like, even if the temperature would exist in the range as described hereinabove. In addition, it is generally preferred that the pressure of nitrogen gas in the heating processing is higher; however, if the pressure of nitrogen gas would exceed 3,000 atm, further improvements in the adhesion of the thin layer of the diamond can be little recognized and rather it suffers from the disadvantage that costs of production may be increased due to an increase in surpluses of pressure. It can be noted herein that the preferred range of the pressure of nitrogen gas may be in the range of usually from 10 to 2,000 atm.

In instances where the supporting members are processed by heating only in the temperature range lower than 1,400° C, on the one hand, the improvements in the characteristics of the supporting members, such as the growth of the fine crystalline particles of $Si_3N_4$, may become so insufficient that the effect of improving the adhesion of the thin layer of the diamond to the supporting member cannot sufficiently be improved, even if the pressure of nitrogen gas would exist within the aforesaid pressure range. In instances where the processing by heating can be carried out at temperature exceeding 1,800 ° C, on the other hand, the silicon nitride ingredient may react with the other ingredients, such as WC, to an excessive extent, thereby impairing desirable characteristics as the supporting members of the silicon nitride ingredient or the like, causing obstacles such as the distortion of the supporting members, and increasing costs of energy.

The processing by heating may be carried out for a period of time in the range of usually from 0.5 hour to 4 hours, preferably from 1 hour to 2 hours.

By subjecting the supporting members to the heating processing at the particular conditions as described hereinabove, the fine crystalline particles of the silicon nitride or the sialone can be allowed to grow on the surfaces of the supporting members in the manner as described hereinabove. In this instance, the fine crystalline particles of the grown silicon nitride or sialone may be usually in the form of acicular crystal and they may have mean effective diameters ranging usually from approximately 0.2 $\mu$m to 3 $\mu$m and mean lengths ranging usually from approximately 2 $\mu$m to 10 $\mu$m. By growing the silicon nitride ingredient to the fine crystalline particles in the manner as described hereinabove, the roughness on the surface of the supporting member can be increased in a uniform manner at microscopic level. As an example, Rmax of the supporting member, indicative of roughness on the surface of the supporting member, can be increased, for example, from 0.8 $\mu$m to as long as 2.4 $\mu$m, by the heating processing. Further, although other desired effects can be expected to be attained as the effect for transforming the supporting members by the heating processing, the supporting members processed by the heating processing can be provided with superior characteristics capable of improving the adhesion of the thin layer of the diamond, as compared with the conventional supporting members which are not subjected to the processing by heating.

(3) Formation of the film of the diamond

In accordance with the modes of the process according to the present invention, the thin layer of the diamond is coated on the desired surface of the supporting members which have been subjected to the heating processing.

As the procedures for forming the thin layer of the diamonds, a description has already been made in the paragraphs entitled (2) diamond-coated members above so that a detailed description thereof will be omitted from the description which follows.

BEST MODE FOR CARRYING OUT THE INVENTION

Although the present invention will be further described more in detail by way of the working examples with reference to the comparative examples, however, it should be noted that the present invention is not restricted to those working examples as will be described hereinafter.

In the working examples and the comparative examples, the adhesion of the thin layer of the diamond to the supporting member will be assessed in a manner as will be described hereinafter.

Procedures for assessing adhesion of diamond thin layer (indentation method)

The adhesion of the thin layer of the diamond to the supporting members will be assessed by ratings, large or small, on the basis of values measured by inserting an indenter into the supporting member from the surface of the diamond thin layer of a test specimen (a supporting member coated with a thin layer of a diamond) and measuring an area, from which the thin layer of the diamond is peeled off, with the indenter of a Rockwell scaler at the load of 60 Kg•f for the retention time of 30 seconds.

Confirmation of the layer of the solid solution

The layer of the solid solution is analyzed with the aid of X-ray analysis techniques. The lattice constants measured by the X-ray analysis of the surfaces of the supporting members in the working examples are shown in Tables 1 and 2 below.

It is confirmed that the lattice constant of the WC is 4.214 Å .

As the lattice constants as shown in Tables 1 and 2 are different from that of the WC, it is found that the solid solution has been formed. The presence of the solid solution can also be confirmed from the result of the SEM observation of a section of the thermally processed supporting member having the plane thereof that the contrast of the surface in the supporting member of a photograph of a section of the supporting member is different from that of the inside of the supporting member and, further, from the composition of the surface of the supporting member by EDAX.

Examples 1-7:

Supporting members made of a superhard alloy, each having a 12.7 mm x 12.7 mm area, were subjected to heating at the conditions for forming the layer of the solid solution, as shown in Table 1 below.

In each of the examples 1 to 7, the thin layer of the diamond was formed on the surface of the supporting member having the layer of the solid solution formed thereon by the heating processing at the conditions as described hereinabove, thereby yielding the member coated with the diamond. It was found that each of the members coated with the diamond formed in the manner as described hereinabove had the thickness of 25 $\mu$m.

Conditions of the synthesis of the thin layer of a diamond

Gases as raw material: mixed gases consisting of CO (15% by volume) and $H_2$ (85% by volume)

Conditions of synthesis: reaction pressure, 40 Torr; temperature on the surface of the supporting member, 900 ° C; synthesis time, 10 hours

Synthesis method (method for exciting gases as raw material): microwave plasma CVD method

The fact that the formed film was comprised of diamond is confirmed by means of Raman spectroscopy. Each of the members coated with the diamond (test specimens) prepared in the manner as described hereinabove was assessed for its adhesion of the thin layer of the diamond to the supporting member by the indentation method. The assessment results are shown in Table 1 below.

Examples 8-19:

The 12.7 mm x 12.7 square supporting members to be employed for tips for cutting tools, as shown in Table 2 below, were coated on their surfaces with a thin layer having the thickness of 1.5 $\mu$m, consisting of a coating as shown in Table 2, by the aid of the sputtering method. In Example 13, a supporting member made of a cermet was used as the test supporting member. Thereafter, reference symbols K01, K10, K20, and P10 used for the supporting members made of the superhard alloy indicate use classification symbols for superhard alloy tips on the basis of JIS B 4053. These superhard alloy have the composition as will be described hereinafter.

Composition of the supporting members made of superhard alloys

K01:
WC-Co type (W: 91% by weight, Co: 5% by weight, C: 4% by weight)
K10:
Superhard alloy of a WC-Co type (W: 87% by weight, Co: 7% by weight, C: 6% by weight)
K20:
Superhard alloy of a WC-Co type (W: 87% by weight, Co: 8% by weight, C: 5% by weight)
P10:
Superhard alloy of a WC-TiC-TaC-Co type (W: 50% by weight, Ti: 16% by weight, Ta: 17% by weight, Co: 9% by weight, C: 8% by weight)
Cermet:
TiN-Ni type (Ti: 59% by weight, Ni: 6% by weight, Co: 9% by weight, Ta: 20% by weight, Mo: 6% by weight)

20

The thin layer of the diamond was formed on the surface of the supporting member having the layer of the solid solution by the heating processing in substantially the same manner as in Examples 1 to 7, thereby yielding the member coated with the diamond. It can be noted herein that each of the formed thin layer of the diamond had nearly 25 $\mu$m.

The fact that the formed film was comprised of diamond is confirmed by means of Raman spectroscopy. Each of the diamond-coated members (test specimens) prepared in the manner as described hereinabove was assessed for its adhesion of the thin layer of the diamond to the supporting member by the indentation method. The assessment results are shown in Table 2 below.

(Comparative Examples 1-5)

In Comparative Examples 1 to 4, the thin layer of the diamond was formed on the surface of a 12.7 mm x 12.7 mm supporting member of a superhard alloy, to be employed as a tip for a cutting tool at substantially the same conditions as in the previous examples, without forming any layer of a solid solution. In Comparative Example 5, the thin layer of the diamond was formed on the surface of a supporting member having the composition as shown in Table 1 below in substantially the same manner as in the previous examples, without forming any layer of a solid solution. The adhesion of the thin layer of the diamond is assessed in substantially the same manner as in the previous examples. The results of Comparative Examples 1 to 4 are shown in Table 3 below, and the result of Comparative Example 5 is shown in Table 1 below.

T A B L E  1

| | Sup-port-ing Member | Conditions for Forming Solid Solution Layer | | | | | Layer of Solid Solution | | | | | |
|---|---|---|---|---|---|---|---|---|---|---|---|---|
| | | Heat-ing Means | Atmos-phere | Pres-sure (atm) | Tem-pera-ture (°C) | Time (min) | Thick-ness (μm) | Po-ro-si-ty (%) | BET Va-lue | Peel Area (mm²) | Ad-he-sion | Lat-tice con-stant |
| Ex. 1 | WC + Co (5%) + TiC (2.5%) | Heat-er | Ar | 2,000 | 1,350 | 180 | 20 | 60 | 160 | LP | HG | 4.29 |
| Ex. 2 | WC + Co (5%) + TiC (2.5%) | Heat-er | N₂ | 1,350 | 1,300 | 180 | 10 | 50 | 120 | LP | HG | 4.32 |
| Ex. 3 | WC + Co (5%) + TiC (2.5%) | HF (4 MHz) | – | 1 | 1,350 | 10 | 10 | 40 | 100 | LP | HG | 4.30 |
| Ex. 4 | WC + Co (5%) + TiC (2.5%) | HF (4 MHz) | – | 1 | 1,300 | 5 | 5 | 30 | 85 | LP | HG | 4.30 |

EP 0 549 801 A1

| | | | | | | | | | | | | |
|---|---|---|---|---|---|---|---|---|---|---|---|---|---|
| Ex. 5 | WC + Co (5%) + TiC (2.5%) | DC | - | 1 | 1,350 | 10 | 10 | 40 | 100 | LP | HG | 4.29 |
| Ex. 6 | WC + Co + TaC (5%) | Heat-er | Ar | 2,000 | 1,350 | 180 | 30 | 50 | 120 | LP | HG | 4.32 |
| Ex. 7 | WC + Co + NbC (5%) | Heat-er | Ar | 2,000 | 1,350 | 180 | 18 | 40 | 100 | LP | HG | 4.37 |
| Comp Ex. 5 | WC + Co + TiC | No processing by heating carried out | | | | | | -- | -- | 0.18 | LW | -- |

Notes: LP = Little peeled off
HG = High; LW = Low
HF = High-frequency heating
DC = Direct Current

EP 0 549 801 A1

| | Coat-ing/ Sup-port-ing Member | Conditions for Forming Solid Solution Layer | | | | | Layer of Solid Solution | | | | | |
|---|---|---|---|---|---|---|---|---|---|---|---|---|
| | | Heat-ing Means | Atmos-phere | Pres-sure (atm) | Tem-pera-ture (°C) | Time (min.) | Thick-ness (μm) | Po-ro-si-ty (%) | BET Va-lue | Peel Area | Ad-he-sion | Lat-tice con-stant |
| Ex. 8 | TiC/ K10 | Heat-er | Ar | 2,000 | 1,400 | 30 | 7 | 60 | 160 | LP | HG | 4.40 |
| Ex. 9 | TiC/ K10 | Heat-er | Ar | 2,000 | 1,350 | 60 | 5 | 50 | 120 | LP | HG | 4.39 |
| Ex. 10 | TiC/ K10 | Heat-er | Ar | 2,000 | 1,300 | 120 | 3 | 40 | 100 | LP | HG | 4.38 |
| Ex. 11 | TiCN/ K10 | Heat-er | Ar | 2,000 | 1,350 | 120 | 5 | 50 | 120 | LP | HG | 4.38 |
| Ex. 12 | TaC/ K10 | Heat-er | Ar | 2,000 | 1,350 | 300 | 7 | 60 | 160 | LP | HG | 4.42 |
| Ex. 13 | TaC/ TiN + Ni | Heat-er | $N_2$ | 2,000 | 1,300 | 30 | 10 | 70 | 220 | LP | HG | 4.27 |

EP 0 549 801 A1

| | | | | | | | | | | | | |
|---|---|---|---|---|---|---|---|---|---|---|---|---|
| Ex. 14 | TiC/ K20 | Heat-er | $N_2$ | 1,350 | 1,350 | 120 | 5 | 40 | 100 | LP | HG | 4.32 |
| Ex. 15 | TiC/ K01 | Heat-er | $N_2$ | 1,350 | 1,350 | 60 | 4 | 50 | 120 | LP | HG | 4.30 |
| Ex. 16 | NbC/ K10 | Heat-er | Ar | 2,000 | 1,350 | 180 | 5 | 40 | 100 | LP | HG | 4.36 |
| Ex. 17 | NbC/ K01 | Heat-er | Ar | 1,350 | 1,350 | 180 | 4 | 40 | 100 | LP | HG | 4.34 |
| Ex. 18 | TiN/ K10 | Heat-er | Ar | 2,000 | 1,350 | 180 | 5 | 60 | 160 | LP | HG | 4.39 |
| Ex. 19 | TiC/ P10 | Heat-er | Ar | 2,000 | 1,300 | 300 | 35 | 70 | 220 | LP | HG | 4.38 |

Notes: LP = Little peeled off

HG = High

TABLE 3

| Coating/ Supporting Member | Conditions for Forming Solid Solution Layer | | | | | Layer of Solid Solution | | | | | |
| | Heating Means | Atmosphere | Pressure (atm) | Temperature (°C) | Time (min) | Thickness (μm) | Porosity (%) | BET Value | Peel Area (mm²) | Adhesion | Lattice constant |
|---|---|---|---|---|---|---|---|---|---|---|---|
| Comp Ex. 1 | TiC/K10 | No processing by heating carried out | | | | | | — | — | 0.21 | LW | — |
| Comp Ex. 2 | TiCN/K10 | | | | | | | — | — | 0.20 | LW | — |
| Comp Ex. 3 | TaC/K10 | | | | | | | — | — | 0.22 | LW | — |
| Comp Ex. 4 | TiCN/K20 | | | | | | | — | — | 0.21 | LW | — |

Notes: LW = Low

Examples 20-29:

The supporting member was prepared by coating a 12.7 mm x 12.7 mm member of a superhard alloy type (K10, M10 or P10), as a tip for cutting tool, with a coating (a titanium coating) consisting of TiN, TiCN

26

or TiC or TiC and by heating the coated layer at the conditions as will be shown in Table 4 below. The symbols K10, M10 and P10 for superhard alloy type supporting members are indicated by the use classification symbols (JIS B-4053) for the superhard alloy tips and the superhard alloy has the composition as will be described hereinafter.

Composition of supporting members of superhard alloy type

K10: The superhard alloy K10 has the composition as described hereinabove.

M10:

Superhard alloy of a WC-TiC-TaC-Co type (W: 70% by weight, Ti: 7% by weight, Ta: 7% by weight, Co: 8% by weight )

P10: The superhard alloy P10 has the composition as described hereinabove.

After the heating processing, the supporting member of the superhard alloy type having the titanium coating was subjected to scratching processing on the face (at least on the face of the titanium coating) of the supporting member with grinding diamond granules having a mean particle size of 10 $\mu$m. Thereafter, the thin layer of a diamond was formed on the face of the supporting member at the conditions as will be described hereinafter. The thickness fo the formed thin layer of a diamond was nearly 25 $\mu$m in each case.

Conditions for the synthesis of thin layers of a diamond

The conditions for the synthesis of the thin layer of the diamond on the surface of the supporting member are the same as in the previous working examples.

For the diamond-coated members (test specimens) formed in the manner as described hereinabove, the adhesion between the thin layer of the diamond and the supporting member was assessed by the indentation method. The test results are shown in Table 4 below.

Comparative Examples 6-13:

As will be shown in Table 4 below, the supporting member of the superhard alloy type having the same titanium coating as in Examples 20 to 28 was subjected to the scratching processing and coated with the thin layer of a diamond on the surface of the supporting member in substantially the same manner as in Examples 1 to 10, thereby yielding the members coated with the diamond. In Comparative Examples 6 to 13, the supporting members were coated with the diamond thin layers without carrying out the heating processing and, in Comparative Example 14, the heating processing was carried our at the conditions as will be described in Table 4 below. The thickness of the thin layer of the diamond in each case was found to be as thick as nearly 25 $\mu$m.

The diamond-coated members(test specimens) were then assessed for their adhesion between the thin layers of the diamond and the supporting members in substantially the same manner as Examples 20 to 29. The test results will be shown in Table 4 below.

## T A B L E 4

| | Superhard Alloy Supporting Member | | Conditions for Heating Processing | | | | | | |
|---|---|---|---|---|---|---|---|---|---|
| | Member | Titanium Coating (*1) | Atmosphere | Pressure (atm) | Processing Temp. (°C) | Processing Time (min) | Peeled Area (mm$^2$) (*2) | Adhesion (*3) |
| Ex. 20 | K10 | TiN | Ar | 2,000 | 1,400 | 30 | 0.05 | High |
| Ex. 21 | K10 | TiCN | Ar | 2,000 | 1,400 | 30 | 0.05 | High |
| Ex. 22 | K10 | TiC | N$_2$ | 2,000 | 1,400 | 30 | 0.05 | High |
| Ex. 23 | M10 | TiN | Ar | 2,000 | 1,350 | 120 | 0.05 | High |
| Ex. 24 | M10 | TiCN | Ar | 2,000 | 1,350 | 120 | 0.05 | High |
| Ex. 25 | M10 | TiC | N$_2$ | 2,000 | 1,350 | 120 | 0.05 | High |
| Ex. 26 | P10 | TiN | Ar | 2,000 | 1,300 | 300 | 0.05 | High |
| Ex. 27 | P10 | TiCN | Ar | 2,000 | 1,300 | 300 | 0.05 | High |
| Ex. 28 | P10 | TiC | N$_2$ | 2,000 | 1,300 | 300 | 0.05 | High |
| Ex. 29 | K10 | Ti | N$_2$ | 2,000 | 1,400 | 30 | 0.05 | High |

EP 0 549 801 A1

| | | (*1) | (*2) | (*3) |
|---|---|---|---|---|
| Comp. Ex. 6 | K10 | TiN | No Heating Processing | 0.21 | Low |
| Comp. Ex. 7 | K10 | TiCN | No Heating Processing | 0.20 | Low |
| Comp. Ex. 8 | K10 | TiC | No Heating Processing | 0.18 | Low |
| Comp. Ex. 9 | M10 | TiN | No Heating Processing | 0.22 | Low |
| Comp. Ex. 10 | M10 | TiCN | No Heating Processing | 0.20 | Low |
| Comp. Ex. 11 | M10 | TiC | No Heating Processing | 0.19 | Low |
| Comp. Ex. 12 | P10 | TiN | No Heating Processing | 0.26 | Low |
| Comp. Ex. 13 | P10 | TiCN | No Heating Processing | 0.24 | Low |
| Comp. Ex. 14 | P10 | TiC | (*4) 2,000 | 1,400 | 180 | Supporting Member Distorted |

Notes: (*1) Thickness of titanium coating (TiN: 1.5 µm; TiCN: 1.5 µm; TiC: 1.5 µm; Ti: 1 µm)

(*2) Indentation Method

(*3) Adhesion of diamond thin layers

(*4) $O_2$ (10% by volume)/Ar (90% by volume)

Example 30:

As the supporting member, there was employed a 12.7 mm x 12.7 mm supporting member containing 91.8% by weight of tungsten carbide, 2.9% by weight of titanium carbide, and 4.9% by weight of cobalt as

29

major ingredients. The supporting member was subjected to heating processing at 1,400° C in an atmosphere of argon gas at pressure as high as 2,000 atm over the period of 1 hour. The observation of the thermally processed surface of the supporting member with an electron microscope revealed that the surface thereof was provided with crystals having projections as long as 2 to 3 $\mu$m.

Thereafter, the supporting member was placed on a supporting table in a reactor tube for the synthesis of diamond, followed by blowing mixed gases consisting of 30% by volume of carbon monoxide gas and hydrogen gas through the reactor tube and then by forming diamond on the surface of the supporting member by applying microwaves having the frequency of 2.45 GHz in accordance with the plasma CVD method.

In addition, the process herein above was carried out in the reactor tube at the temperature of 800 ° C and the reduced pressure of 400 torr over the period of 5 hours and them the thin layer of a diamond with having a thickness was 5 $\mu$m was formed on the surface of the supporting member.

The resulting member coated with the diamond was then assessed for its adhesion between the thin layer of the diamond and the basic plate by the indentation method.

The test results will be shown in Table 5 below. As shown in Table 5 below, the peeled area was found to be 0.05 mm$^2$ and the adhesion between the film of the diamond and the supporting member was high.

Example 31:

The member coated with the diamond was prepared in substantially the same manner as in Example 30, except for the use of the supporting member having the composition consisting of 76.8% by weight of tungsten carbide, 8.6% by weight of titanium carbide, and 3.9% by weight of cobalt. The resulting member coated with the diamond was assessed for its adhesion between the film of the diamond and the supporting member in substantially the same manner as in Example 30.

The test results will be shown in Table 5 below. As shown in Table 5 below, the peeled area was found to be 0.05 mm$^2$ and the adhesion between the film of the diamond and the supporting member was high.

Comparative Example 15:

The member coated with the diamond was prepared in substantially the same manner as in Example 30, except for no heating processing carried out. The resulting member coated with the diamond was assessed for its adhesion between the film of the diamond and the supporting member in substantially the same manner as in Example 30.

The test results will be shown in Table 5 below. As shown in Table 5 below, the peeled area was found to be as large as 0.14 mm$^2$ and the adhesion between the film of the diamond and the supporting member was low.

Comparative Example 16:

The member coated with the diamond was prepared in substantially the same manner as in Example 30, except for the heating processing being carried out at the temperature of 1,400° C and the reduced pressure of $10^{-3}$ torr over the period of 1 hour. The resulting member coated with the diamond was assessed for its adhesion between the film of the diamond and the supporting member in substantially the same manner as in Example 30.

The test results will be shown in Table 5 below. As shown in Table 5 below, the peeled area was found to be as large as 0.16 mm$^2$ and the adhesion between the film of the diamond and the supporting member was low.

TABLE 5

|  | Peeled Area ($mm^2$) | Adhesion |
|---|---|---|
| Example 30 | 0.05 | High |
| Example 31 | 0.05 | High |
| Comparative Example 15 | 0.14 | Low |
| Comparative Example 16 | 0.16 | Low |

Example 32:

A 12.7 mm (long) x 12.7 mm (wide) x 2 mm (thick) supporting member was prepared from a superhard alloy consisting of 91% by weight of tungsten carbide, 3% by weight of tantalum carbide, and 6% by weight of cobalt and subjected to heating processing at 1,400°C for 30 minutes in an atmosphere of argon gas at the pressure of 2,000 atm.

Thereafter, the supporting member was placed on a supporting table in a reactor tube for the synthesis of diamond, followed by blowing mixed gases consisting of 30% by volume of carbon monoxide gas and hydrogen gas through the reactor tube and then by forming diamond on the surface of the supporting member by applying microwaves having the frequency of 45 GHz in accordance with the plasma CVD method. The member coated with the diamond was prepared by setting the pressure of the reactor tube to 40 Torr, the temperature of the supporting member to 800°C, and the reaction time to 5 hours, thereby giving the thin layer of the diamond having the thickness of 5 μm.

The film of the diamond of the resulting member coated with the diamond was assessed for its adhesion in substantially the same manner as in Example 30. The test results are shown in Table 6 below.

Examples 33-35:

The members coated with the diamond were prepared in substantially the same manner as in Example 32 except for the application of the conditions as will be shown in Table 6 below. The test results are shown in Table 6 below.

Comparative Example 17-19:

The members coated with the diamond were prepared in substantially the same manner as in Example 32 except for the application of the conditions as will be shown in Table 6 below. The test results are shown in Table 6 below.

TABLE 6

| | Conditions for Heating Processing | | | | Peeled Area (mm²) | Adhesion (-) |
|---|---|---|---|---|---|---|
| | Atmospheric Gas | Pressure (atm) | Temperature (°C) | Time (min) | | |
| Example 32 | Argon | 2,000 | 1,400 | 30 | 0.12 | High |
| Example 33 | Nitrogen | 2,000 | 1,400 | 30 | 0.12 | High |
| Example 34 | Argon | 10 | 1,400 | 30 | 0.12 | High |
| Example 35 | Nitrogen | 10 | 1,400 | 30 | 0.12 | High |
| Comparative Example 17 | Argon | 2,000 | 1,100 | 60 | - | *1 |
| Comparative Example 18 | Argon | 2,000 | 1,600 | 30 | 0.12 | *2 |
| Comparative Example 19 | Argon | 1 | 1,400 | 30 | - | *3 |

Notes: *1: Layer peeled off at corners.
*2: Supporting member was curved.
*3: Layer peeled off at corners.

Example 36:

A 12.7 mm (length) x 12.7 mm (width) x 2 mm (thickness) supporting member prepared from a superhard alloy consisting of 94% by weight of tungsten carbide and 6% by weight of cobalt was subjected to heating processing at 1,400° C in an atmosphere of argon gases at the pressure of 2,000 atm over the period of 30 minutes, followed by allowing the resulting supporting member to cool at natural conditions.

Then, the resulting supporting member was subjected to plasma processing at output of 350 W by using microwaves having frequency of 2.45 GHz and heating the supporting member at the temperature of 900 ° C under the reduced pressure of 40 Torr while blowing mixed gases consisting of 70% by volume of carbon dioxide gases and 30% by volume of hydrogen gas at the gas flow rate of 10 sccm.

The resulting supporting member was then placed on a supporting table in a reactor tube for the synthesis of diamond, and the thin layer of the diamond was formed by the plasma CVD method by introducing mixed gas consisting of 15% by volume of carbon monoxide gas and hydrogen gas as raw gas and using microwaves having the frequency of 2.45 GHz. The conditions for forming the thin layer of the diamond was such that the pressure of the reactor tube was set to 40Torr, the temperature of the supporting member was set to 800° C, and the reaction was carried out for 5 hours.

The thin layer of the diamond of the resulting member coated with the diamond was assessed for its adhesion in substantially the same manner as in the previous examples. As a result, it was found that the peeled area in which the thin layer of the diamond was peeled off was 0.05 mm$^2$ and the adhesion was extremely good.

Examples 37-44:

The 12.7mm (length) x 12.7 mm (width) x 2 mm (thickness) supporting members prepared from cermet of a tungsten carbide type or of a titanium nitride type having the composition as will be shown in Table 7 below and they were subjected to heating processing at the conditions as will be shown in Table 7 below.

Thereafter, each of the supporting members was placed on a supporting table in a reactor tube for the synthesis of diamond and mixed gases consisting of 30% by volume of carbon monoxide gas and hydrogen gas were allowed to flow through the reactor tube. Then, the microwaves having the frequency of 2.45 GHz was introduced, thereby forming diamond by the plasma CVD method.

The reaction was carried out by setting the pressure within the reactor tube to 40 torr, the temperature on the surface of the supporting member to 900° C, and the reaction time to 5 hours. As a result, it was found that the film of the diamond was formed in the thickness of 10 $\mu$m.

The resulting member coated with the diamond was assessed for its adhesion between the film of the diamond and the supporting member by the indentation method.

The test results will be shown in Table 7 below. As shown in Table 7, the peeled area in which the film of the diamond was peeled off from the supporting member was found to be as wide as 0.05 mm$^2$ and the adhesion between the film of the diamond and the supporting member was found high.

Comparative Examples 20-22:

The members coated with the diamond were prepared in substantially the same manner as in Examples 37-45, except for the conditions for the heating processing being changed as in a manner as will be shown in Table 7 below. The resulting members coated with the diamond were assessed for their adhesion between their film of the diamonds and the supporting members in substantially the same manner as in Examples 37-45. The test results are shown in Table 7 below.

EP 0 549 801 A1

T A B L E   7

| | Composition of Supporting Member (by weight) | Conditions for Heating Processing | | | | Adhesion (mm$^2$) |
|---|---|---|---|---|---|---|
| | | Atmos-phere | Pres-sure (atm) | Tempe-rature (°C) | Time (min) | |
| Example 37 | TiC (57%)-MoC (19%)-Ni (24%) | Ar | 2,000 | 1,400 | 30 | 0.05 |
| Example 38 | TiC$_{0.7}$N$_{0.3}$ (74%)-Ni (26%) | Ar | 2,000 | 1,400 | 30 | 0.05 |
| Example 39 | TiC (57%)-MoC (19%)-Ni (24%) | N$_2$ | 2,000 | 1,400 | 30 | 0.05 |
| Example 40 | TiC$_{0.7}$N$_{0.3}$ (74%)-Ni (26%) | N$_2$ | 2,000 | 1,400 | 30 | 0.05 |
| Example 41 | TiC (57%)-MoC (19%)-Ni (24%) | Ar | 10 | 1,400 | 30 | 0.05 |
| Example 42 | TiC$_{0.7}$N$_{0.3}$ (74%)-Ni (26%) | Ar | 10 | 1,400 | 30 | 0.05 |
| Example 43 | TiC (57%)-MoC (19%)-Ni (24%) | N$_2$ | 10 | 1,400 | 30 | 0.05 |

34

| | | | | | | |
|---|---|---|---|---|---|---|
| Example 44 | $TiC_{0.7}N_{0.3}$ (74%)-Ni (26%) | $N_2$ | 10 | 1,400 | 30 | 0.05 |
| Comparative Example 20 | TiC (57%)-MoC (19%)-Ni (24%) | Ar | 2,000 | 1,100 | 30 | Layer Peeled |
| Comparative Example 21 | TiC (57%)-MoC (19%)-Ni (24%) | Ar | 2,000 | 1,600 | 30 | 0.05(*1) |
| Comparative Example 22 | TiC (57%)-MoC (19%)-Ni (24%) | – | In Vacuo $10^{-3}$ Torr | 1,400 | 30 | Layer Peeled |

Note: (*1) The supporting member was distorted.

Examples 45-50 And Comparative Examples 23-29:

A material of a silicon nitride type prepared by sintering a mixture of raw materials consisting of 92% by weight of silicon nitride ($Si_3N_4$), 3% by height of titanium nitride (TiN), and 5% by weight of a sintering

aid ($Y_2O_3$) was subjected to grinding processing, thereby yielding a supporting member in the form of a throw away tip (SPGN-120308). The resulting supporting members were subjected to heating processing over the period of 1 hour in the atmosphere of gases of the kind as shown in Table 1, at the gas pressure as shown in Table 8, and at the temperature as shown in Table 8. It was found that the heating processing increased the surface roughness (Rmax) of the supporting member from 0.8 $\mu$m to as large as 2.0 $\mu$m. Further, the electron microscopic observation revealed that bulky particles of silicon nitride ($Si_3N_4$) were formed on the surface of the supporting member after the processing by heating.

Thereafter, the resulting supporting members were placed on a supporting table and equipped in a reactor for the synthesis of diamond, and the desired members coated with the diamond were prepared by forming the thin layer of the diamond on the surface of each of the supporting members through the diamond synthesis reaction in accordance with the microwave CVD method over the period of 5 hours at the pressure of 40 Torr and the temperature of 1,000° C on the surface of the supporting member while introducing mixed gases consisting of 15% by volume of carbon monoxide and 85% by volume of hydrogen gas.

The resulting members coated with the diamond were found each to have the thin layer of the diamond in the thickness of 12 $\mu$m.

The members coated with the diamond were then subjected to cutting tests under the conditions as will be described hereinafter.

Test material to be tested for cutting: Alloy consisting of Si (12% by volume), Al (87% by volume), and Cu (1% by volume)

Cutting velocity: 800 meters per minute

Feed: 0.1 mm/rev.

Cut depth: 0.25 mm

The test results will be shown in Table 8 below.

It is confirmed from the test results as shown in Table 8 that the supporting members processed by heating in the atmosphere of rare gases at the particular pressure range and the particular temperature range can provide the diamond-coated members with the thin layers of the diamond coated thereon at a high degree of adhesion.

## T A B L E   8

| | Atmos-pheric Gas | Gas Pres-sure (atm) | Heating Temperature (°C) | Heating Time (hour) | Assessment Result | Relative Life ($x$ times) |
|---|---|---|---|---|---|---|
| Example 45 | Argon | 2,000 | 1,650 | 1 | No layer peeled off up to 35,000 m | 1.7 |
| Example 46 | Argon | 2,000 | 1,600 | 1 | No layer peeled off up to 45,000 m | 2.1 |
| Example 47 | Argon | 9.5 | 1,400 | 1 | No layer peeled off up to 36,000 m | 1.7 |
| Example 48 | Argon | 9.5 | 1,600 | 1 | No layer peeled off up to 28,000 m | 1.3 |
| Example 49 | Argon | 2,000 | 1,750 | 1 | No layer peeled off up to 59,000 m | 2.8 |

| Sample | Gas | | | Peel | Peeling test | Value |
|---|---|---|---|---|---|---|
| Example 50 | Argon | 2,000 | 1,850 | 1 | No layer peeled off up to 50,000 m | 2.4 |
| Comparative Example 23 | No heating processing carried out | | | 1 | No layer peeled off up to 21,000 m | 1 |
| Comparative Example 24 | Nitrogen | 2,000 | 1,650 | 1 | No layer peeled off up to 27,000 m | 1.3 |
| Comparative Example 25 | Nitrogen | 9.5 | 1,600 | 1 | No layer peeled off up to 8,800 m | 0.4 |
| Comparative Example 26 | Nitrogen | 9.5 | 1,400 | 1 | No layer peeled off up to 16,000 m | 0.8 |
| Comparative Example 27 | Argon | 1 | 1,400 | 1 | No layer peeled off up to 4,500 m | 0.2 |

| | | | | | | |
|---|---|---|---|---|---|---|
| Comparative Example 28 | Argon | 1 | 1,000 | 1 | No layer peeled off up to 20,000 m | 1.0 |
| Comparative Example 29 | Argon (90% by volume) + Oxygen (10% by volume) | 2,000 | 1,600 | 1 | Supporting member distorted | - - |
| Comparative Example 30 | Oxygen | 1 | 1,600 | 1 | Supporting member distorted | - - |

Example 51:

A material of a silicon nitride type prepared by sintering a mixture of raw materials consisting of 65% by weight of silicon nitride ($Si_3N_4$), 30% by weight of tungsten carbide (WC), and 5% by weight of a

39

sintering aid ($Y_2O_3$) was subjected to grinding processing, thereby yielding a supporting member in the form of a throw away tip (SPGN-120308). The resulting supporting member was subjected to heating processing over the period of 1 hour in the atmosphere of nitrogen gas at the gas pressure of 2,000 atm and at the temperature of 1,650 ° C. It was found that the heating processing increased the surface roughness(Rmax) of the supporting member from 0.8 $\mu$m to as large as 2.4 $\mu$m. Further, the electron microscopic observation revealed that acicular crystalline particles of silicon nitride ($Si_3N_4$) were formed on the surface of the supporting member after the processing by heating.

Thereafter, the resulting supporting member was placed on a supporting table and equipped in a reactor for the synthesis of diamond, and the desired member coated with the diamond were prepared by forming the thin layer of the diamond on the surface of the supporting member through the diamond synthesis reaction in accordance with the microwave CVD method over the period of 5 hours at the pressure of 40 Torr and the temperature of 900° C on the surface of the supporting member while introducing mixed gas consisting of 15% by volume of carbon monoxide and 85% by volume of hydrogen gas.

The resulting member coated with the diamond was found each to have the thin layer of the diamond in the thickness of 20 $\mu$m.

The member coated with the diamond was then subjected to cutting tests under the conditions as will be described hereinafter.

Test material to be tested for cutting: Alloy consisting of Si (12% by volume), Al (87% by volume), and Cu (1% by volume)

Cutting velocity: 800 meters per minute

Feed: 0.1 mm/rev.

Cut depth: 0.5 mm

The test results revealed that no abnormality in the peeling of the thin layer (coating) of the diamond formed on the member coated with the diamond was found up to the cutting distance of 50,000 meters.

In other words, it was confirmed that the member coated with the diamond is provided with a remarkably high degree of adhesion between the thin layer of the diamond and the supporting member, it can demonstrate high performance and durability required for a cutting tool, such as strength, hardness, resistance to abrasion, and soon, and it has an extremely long life.

Example 52:

The member coated with the diamond was prepared in substantially the same manner as in Example 51, with the exception that the pressure of nitrogen gas pressure was set to 9.5 atm. during the period where the supporting member was being subjected to the heating processing. The resulting member coated with the diamond was then tested for its cutting performance in substantially the same manner as in Example 51.

As a result of the cutting test, it was found that no abnormality such as the separation of the thin layer (coating) of the diamond from the supporting member was seen in the cut distance of 50,000 meters.

In other words, the test results revealed that the resulting member coated with the diamond was extremely good in the adhesion between the thin layer of the diamond and the supporting member and it was further confirmed that the member coated with the diamond could show high performance and durability as cutting tools that require severe conditions such as strength, hardness resistance to abrasion, and so on, and it could provide an extremely long life.

Comparative Example 30:

The supporting member was subjected to the heating processing in substantially the same manner as in Example 51, with the exception that the pressure of nitrogen gas during the period of time for heating the supporting member was set to 1 atm. (ambient atmosphere). As a result, it was found that the supporting member was curved and it was found useless as a cutting tip.

Comparative Example 31:

The supporting member used in Example 51 was employed as it was without subjecting it to heating processing at pressurized atmosphere of nitrogen gas, and the thin layer of the diamond was coated on the surface of the supporting member in substantially the same manner as in Example 51.

The resulting member coated with the diamond was then tested for its cutting performance in substantially the same conditions as in Example 51. The test results revealed that a portion of the thin layer (coating) of the diamond was peeled off from the supporting member in the cutting distance of 30,000 meters.

INDUSTRIAL APPLICABILITY

The members coated with the diamond according to the present invention are prepared in such a manner that the particular superhard alloy or cermet is employed as the supporting member; the supporting member is subjected to the heating processing to thereby form the layer of the solid solution that may be a porous layer as needed; and the film of the diamond was formed on the surface of the layer of the solid solution in such a way that the layer of the solid solution itself is tightly secured to the surface of the supporting member and the film of the diamond is in turn secured tightly to the surface of the layer of the solid solution; hence, the film of the diamond is in turn secured tightly to the supporting member, thereby causing no separation of the film of the diamond to occur even at high temperature and providing high durability.

Therefore, the members coated with the diamond according to the present invention can be applied to cutting tools, grinding tools, abrasive tools, and so on, and the resulting tools are found remarkably long in life.

On the other hand, the process according to the present invention can be arranged by preparing the particular superhard alloy or cermet to give the supporting member, subjecting the supporting member to heating processing to form the layer of the solid solution which may be in the form of a porous layer, as needed, and forming the film of the diamond on the surface of the layer of the solid solution. Further, the process according to the present invention are arranged by the particular mode of the process which involves using the supporting member made of the ceramics of the silicon nitride type, subjecting the supporting member to the heating processing in an atmosphere of the particular gases at the temperature and pressure within the particular ranges, and coating the surface of the surface of the thermally processed supporting member with the thin layer of the diamond. Hence, the processes according to the present invention can provide the diamond-coated members having an extremely high degree of practical performance because the adhesion between the thin layer (coating) of the diamond and the supporting member is so remarkably high and strength, hardness, fracture toughness resistance, and so on, of the supporting itself are so high, that the resulting members coated with the diamond can demonstrate a sufficiently high degree of practical performance and durability and provide an extremely prolonged period of life, when they are employed as cutting tools, abrasive tools, and so on.

Further, the members coated with the diamond according to the present invention can appropriately be applied to the cutting tools and so on, because they are extremely high in adhesion between the thin layer of the diamond and the supporting member.

## Claims

1. A member coated with a diamond, characterized by a supporting member having a layer of a solid solution formed on a surface of the supporting member, the solid solution composed of at least one member selected from the group consisting of a carbide of a metal, a nitride thereof, and a carbonitride thereof, said metal comprising two or more kinds of metals selected from the group consisting of the metals belonging to the groups IVA, VA, and VIA of the periodic table; and a thin layer of the diamond formed on a surface of said layer of the solid solution.

2. A member coated with a diamond as claimed in claim 1, wherein thickness of said layer of the solid solution is at least 0.1 $\mu$m or thicker.

3. A member coated with a diamond as claimed in claim 1, wherein said layer of the solid solution is porous.

4. A member coated with a diamond as claimed in claim 2, wherein a porosity of said layer of the solid solution is in the range of from 5% to 80%.

5. A member coated with a diamond as claimed in claim 2, wherein a BET value of said layer of the solid solution is in the range of from 30 to 300 $cm^2$ per gram.

6. A process for the preparation of a member coated with a diamond, characterized by subjecting a supporting member composed of a superhard alloy of a tungsten carbide type to heating processing at temperature ranging from 1,200° C to 1,600° C in an atmosphere of an inert gas at pressure ranging from ambient atmosphere to 3,000 atm and then forming a thin layer of the diamond on a surface of said supporting member by vapor phase method.

7. A process for the preparation of a member coated with a diamond as claimed in claim 6, wherein said superhard alloy of the tungsten carbide type comprises from 50% to 95% by weight of tungsten carbide, from 1% to 30% by weight of titanium carbide, and from 2% to 20% by weight of cobalt.

8. A process for the preparation of a member coated with a diamond as claimed in claim 6, wherein said superhard alloy of the tungsten carbide tape comprises from 80% to 93% by weight of tungsten carbide, from 3% to 10% by weight of tantalum carbide, and from 4% to 10% by weight of cobalt.

9. A process for the preparation of a member coated with a diamond, characterized by subjecting a surface of the supporting member thermally processed in claim 6 to plasma processing in an atmosphere of a mixture of carbon dioxide gas and hydrogen gas at pressure ranging from 10 torr to 100 torr and at temperature ranging from 500° C to 1,100 ° C and forming a thin layer of the diamond on the surface of said supporting member by vapor phase method.

10. A process for the preparation of a member coated with a diamond, characterized by subjecting a supporting member made of a cermet to heating processing in an atmosphere of an inert gas at ambient atmosphere or at pressure of 3,000 atm or lower and forming a thin layer of the diamond on the surface of the thermally processed supporting member by vapor phase method.

11. A process for the preparation of a member coated with a diamond, characterized by subjecting a supporting member having a coating of a thin layer composed of at least one member selected from the group consisting of a metal titanium, a titanium nitride, a titanium carbide, and a titanium carbonitride on a surface of a member of a superhard alloy type to heating processing at temperature ranging from 1,000° C to 1,600° C in an atmosphere of an inert gas and forming a thin layer of the diamond on a surface of the thermally processed supporting member by vapor phase method.

12. A process for the preparation of a member coated with a diamond, characterized by subjecting a supporting member prepared from a ceramics of a silicon nitride type at temperature ranging from 1,300° C to 2,000° C in an atmosphere of a rare gas at pressure ranging from 5 to 3,000 atm and forming a thin layer of the diamond on the surface of the thermally processed supporting member by vapor phase method.

13. A process for the preparation of a member coated with a diamond as claimed in claim 12, wherein said ceramics of the silicon nitride type contains at least one member selected from the group consisting of silicon nitride, $\alpha$ -sialone and $\beta$ -sialone as a major component.

14. A process for the preparation of a member coated with a diamond as claimed in claim 13, wherein at least one member selected from the group consisting of said $\alpha$ -sialone and $\beta$ -sialone is contained at a rate of from 60% to 99% by volume in the supporting member.

15. A process for the preparation of a member coated with a diamond, characterized by subjecting a supporting member prepared from at least one member selected from the group consisting of silicon nitride, $\alpha$ -sialone, and $\beta$ -sialone at a rate of from 30% to 95% by volume and at least one member selected from the group consisting of a metal carbide, a metal nitride, a metal carbonitride, and a metal boride at a rate of from 70% to 5% by volume at temperature ranging from 1,400° C to 1,800° C in an atmosphere of nitrogen gas at pressure ranging from 5 to 3,000 atm and forming a thin layer of the diamond on the surface of the thermally processed supporting member by vapor phase method.

# INTERNATIONAL SEARCH REPORT

International Application No PCT/JP92/00804

| I. CLASSIFICATION OF SUBJECT MATTER (if several classification symbols apply, indicate all) [6] |
|---|
| According to International Patent Classification (IPC) or to both National Classification and IPC |

Int. Cl$^5$  C23C16/26, 16/02, B23P15/28

## II. FIELDS SEARCHED

### Minimum Documentation Searched [7]

| Classification System | Classification Symbols |
|---|---|
| IPC | C23C16/26, 16/02, B23P15/28 |

### Documentation Searched other than Minimum Documentation to the Extent that such Documents are Included in the Fields Searched [8]

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| X | JP, A, 1-246361 (Toshiba Tungaloy Co., Ltd.), October 2, 1989 (02. 10. 89), Line 6, lower left column to line 4, lower right column, page 1 (Family: none) | 1-15 |
| X | JP, A, 1-255630 (Mitsubishi Metal Corp.), October 12, 1989 (12. 10. 89), Line 6, lower left column to line 12, lower right column, page 1 (Family: none) | 6-15 |
| X | JP, A, 61-104078 (Toshiba Tungaloy Co., Ltd.), May 22, 1986 (22. 05. 86), Line 8, lower left column to line 5, lower right column, page 6 (Family: none) | 1-15 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| August 7, 1992 (07. 08. 92) | August 25, 1992 (25. 08. 92) |
| International Searching Authority | Signature of Authorized Officer |
| Japanese Patent Office | |

Form PCT/ISA/210 (second sheet) (January 1985)